# EUROPEAN PATENT APPLICATION

(11) **EP 4 194 949 A1**
(43) Date of publication of application: **14.06.2023**
(21) Application number: 22200779.1
(22) Date of filing: 11.10.2022
(51) Int. Cl.: G03F 7/004, G03F 7/039, G03F 7/075

(54) **PHOTOACID GENERATOR, PHOTORESIST COMPOSITION INCLUDING THE SAME, AND METHOD OF FORMING A PATTERN USING THE PHOTOACID GENERATOR**

(30) Priority: 25.11.2021 KR 20210164871; 23.09.2022 KR 20220121121
(71) Applicant: Samsung Electronics Co., Ltd., Gyeonggi-do 16677 (KR)
(72) Inventor: KIM, Minsang, 16678 Suwon-si (KR); KOH, Haengdeog, 16678 Suwon-si (KR); KIM, Hana, 16678 Suwon-si (KR); KWAK, Yoonhyun, 16678 Suwon-si (KR); KIM, Hyeran, 16678 Suwon-si (KR); LEE, Eunkyung, 16678 Suwon-si (KR); JEON, Aram, 16678 Suwon-si (KR)
(74) Representative: Elkington and Fife LLP

(57) **Abstract**

Provided are a photoacid generator, a photoresist composition including the same, and a method of forming a pattern by using the photoacid generator. The photoacid generator includes a copolymer of a monomer that generates an acid upon exposure to light and an acid-labile monomer of which solubility with respect to a developing solvent is changed by decomposition by an acid, wherein the copolymer is represented by Formula 1: 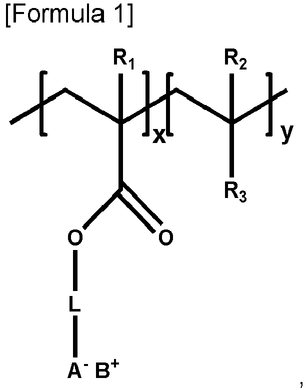 wherein, in Formula 1, x, y, L, A⁻, B⁺, R₁, R₂, and R₃ are each the same as described in the detailed description.

## Description

### FIELD OF THE INVENTION

The present disclosure relates to a photoacid generator, a photoresist composition including the same, and a method of forming a pattern by using the photoacid generator.

### BACKGROUND OF THE INVENTION

In a semiconductor manufacturing process, a photoresist of which physical properties are changed by reaction in response to light is used to form patterns on a surface. Among various kinds of photoresists, chemically amplified photoresists have been the most commonly used until now. Chemically amplified photoresists make patterning possible by using a difference in solubility in a developing solvent. However, when a chemically amplified photoresist is used, after exposure to light, an acid generated by a photoacid generator (PAG) contained in a photoresist composition may be diffused to an unexposed region, causing issues with uniformity or roughness in the pattern. In order to solve this problem, a photo-decomposable quencher (PDQ) is used to inhibit the diffusion of acids into an unexposed region, but there is a limit in sufficiently enlarging the dose which is required upon exposure to light.

Therefore, there is still a need for a photoacid generator having a reduced acid diffusion length in a photoresist film and a similar or improved acid yield, and a photoresist composition including the same.

### SUMMARY OF THE INVENTION

Provided is a photoacid generator having a reduced acid diffusion length in a photoresist film and a similar or improved acid yield.

Provided is a photoresist composition including the photoacid generator.

Provided is a method of forming a pattern by using the photoacid generator.

Additional aspects will be set forth in part in the description which follows and, in part, will be apparent from the description, or may be learned by practice of the presented embodiments of the disclosure.

According to an aspect, there is provided a photoacid generator including
a copolymer of a monomer that generates an acid upon exposure to light and an acid-labile monomer of which solubility with respect to a developing solvent is changed by decomposition by an acid, wherein the copolymer is represented by Formula 1: 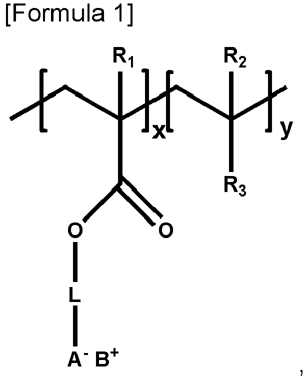 wherein, in Formula 1,
a molar ratio of x and y is 1: 1 to 1: 5, and a number average molecular weight (Mn) of the copolymer is 500 g/mol to 5,000 g/mol,
L is a single bond or a substituted or unsubstituted C1-C20 alkylene group,
A⁻ is a sulfonic acid anion or a carboxylic acid anion,
B⁺ is a sulfonium-based cation that is unsubstituted or substituted with a halogen atom or a C1-C20 haloalkyl group, or an iodonium-based cation that is unsubstituted or substituted with a halogen atom or a C1-C20 haloalkyl group,
R₁ and R₂ are each independently a hydrogen atom, a halogen atom, or a substituted or unsubstituted C1-C10 alkyl group,
R₃ is one of groups represented by Formulae 1-1 and 1-2:

   [Formula 1-1] *-C(=O)O(L₁)ₙRₐ

   [Formula 1-2] *-OR_{b},

   wherein
L₁ is a C1-C10 alkylene group that is unsubstituted or substituted with a C1-C5 alkyl group,
n is an integer of 0 to 10,
Rₐ is a substituted or unsubstituted C4-C20 t-alkyl group, a substituted or unsubstituted C3-C50 aliphatic cyclic group, a substituted or unsubstituted C3-C60 heteroaliphatic cyclic group, a substituted or unsubstituted C3-C60 heteroaromatic cyclic group, or -OC(=O)ORₐ₁, wherein Rₐ₁ is a C1-C10 alkyl group,
R_{b} is -Si(R_{b1})(R_{b2})(R_{b3}) or -C(R_{b4})(R_{b5})O(R_{b6}), wherein R_{b1}, R_{b2}, R_{b3}, R_{b4}, R_{b5}, and R_{b6} are each independently a hydrogen atom, a C1-C10 alkyl group or a C6-C20 aryl group, and
* is a binding site.

According to another aspect, there is provided a photoresist composition including
the photoacid generator, a base polymer, a photo-decomposable quencher (PDQ), and a solvent.

According to another aspect, there is provided a method of forming a pattern, the method including
forming a photoresist film by applying the photoresist composition on aboard;
exposing at least a portion of the photoresist film with high-energy rays; and
developing the exposed photoresist film by using a developer solution.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic diagram showing the principle of a chemically amplified photoresist;
FIG. 2 is a schematic diagram showing a change in roughness due to acid diffusion after exposure to light on a photoresist film;
FIG. 3 represents a chemical structure of a photoacid generator according to an embodiment;
FIG. 4 represents a photoacid generator according to an embodiment having a chemical structure of which solubility differs before and after exposure to light
FIG. 5 represents a method of measuring acid diffusion length according to Evaluation Example 1;
FIG. 6 is a flowchart representing a pattern forming method according to an embodiment;
FIG. 7 is a side cross-sectional view illustrating a pattern forming method according to an embodiment; and
FIGS. 8 to 13 respectively represent ¹H-NMR of PAG 1 to PAG 6 synthesized in Synthesis Examples 1 to 6.

### DETAILED DESCRIPTION OF THE EMBODIMENTS

Reference will now be made in detail to embodiments, embodiments of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of at least one of the associated listed items. Expressions such as "at least one of" when preceding a list of elements, modify the entire list of elements and do not modify the individual elements of the list.

Hereinafter, a photoacid generator according to an embodiment of the present invention, a photoresist composition including the same, and a method of forming a pattern including the photoacid generator will be described in detail, referring to the attached drawings. The described herein are given as examples and the present disclosure is not limited thereto, but is only defined by the scope of the appended claims.

As used herein, expressions such as "at least one of," "at least one," "one or more" when preceding a list of elements, modify the entire list of elements and do not modify the individual elements of the list. As used herein, the term "combination," unless otherwise specified, includes a mixture, reaction product, and the like.

As used herein, the term "include," unless otherwise specified, does not mean an exclusion of another component but other components may be further included.

As used herein, the terms "a first," "a second," and the like do not imply an order, a quantity, or an importance, but are used to distinguish one component from other components. As used herein, the singular of any term includes the plural, and vice versa, unless otherwise specified or the context otherwise requires. As used herein, the expression "or" means "and/or" unless otherwise specified.

As used herein throughout the disclosure, the terms "an embodiment," "embodiments," "exemplary embodiment" and the like mean a specific element described in connection with an embodiment is included in at least one embodiment described herein and may or may not exist in other embodiments. Also, it should be understood that the described elements may be combined in any suitable manner in various embodiments.

Unless otherwise defined, technical or scientific terms used herein have the same meanings as generally understood by those skilled in the art to which the present disclosure belongs. When a terminology of the present specification is contradicted or collides with the terminology of a cited reference, the term from the present specification takes precedence over the conflicting term in the cited reference. Although specific embodiments and implementations have been described, currently unpredicted, or unpredictable alternatives, modifications, variations, improvements, and substantial equivalents, may arise to the applicant or those skilled in the art. Thus, the appended claims and revision objects are intended to include all such alternatives, modifications, variations, improvements, and substantial equivalents.

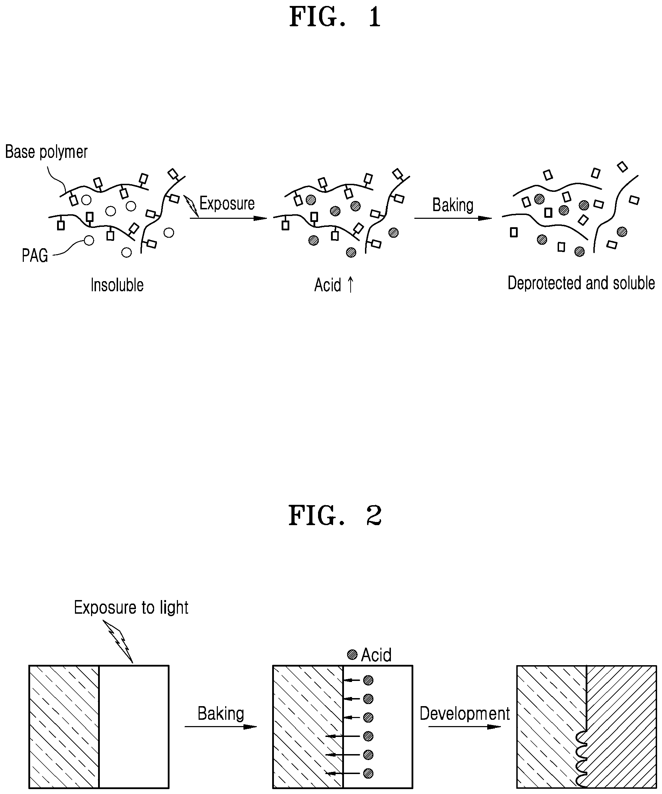

FIG. 1 is a schematic diagram showing the principle of a chemically amplified photoresist.

As shown in FIG. 1, unlike in the case of photoresists of the related art, in the case of a chemically amplified photoresist, an acid reactive polymer, for example, a base polymer or a compound does not react to light directly, and an acid is generated by a photoacid generator (PAG) of the chemically amplified photoresist in the region exposed to light and thus only a latent image is formed. Then, in the next step of a post exposure bake (PEB), the generated acid acts as a catalyst to an acid reactive polymer, for example, a base polymer, to amplify chemical reactions, and a solubility with respect to a developing solvent is changed. Thus, a photosensitivity of the chemically amplified photoresist is determined depending on a change in the solubility of exposed and unexposed regions on a photoresist film due to an acid catalytic reaction by heat during a post exposure bake (PEB).

FIG. 2 is a schematic diagram showing a change in roughness of a photoresist film due to an acid diffusion after exposure to light.

Referring to FIG. 2, a difference in acid diffusion length may be generated on a photoresist film in a post exposure bake, and according to the difference in acid diffusion length, a difference of solubility in a developing solvent is generated in the development process, which in turn generates a difference of roughness of a photoresist film. It is shown that, as an acid diffusion length in a photoresist film is increased, the roughness of the photoresist film is increased. Therefore, in order to reduce the roughness of a photoresist film, it is necessary to reduce the acid diffusion length (ADL) of the photoacid generator (PAG) to minimize the diffusion to the unexposed region.

As a method of reducing an acid diffusion length (ADL) of a photoacid generator, a hydrophilic functional group such as -OH is used as an anion or cation of a photoacid generator to reduce the movement of an acid in a base polymer used as a matrix. However, according to this the final pattern may be broken because a photoacid generator is dissolved in a developing solvent not only in exposed regions but also in unexposed regions. In another method, the photoacid generator is introduced into the base polymer itself and the photoacid generator is not separately added (PAG bond polymer). In this method, however, the solubility with respect to a solvent used for forming the photoresist film may be reduced, making it difficult to use photo-acid generators of various compositions, and having a limitation in increasing the content of photo-acid generators.

The inventors of the present disclosure will provide a photoacid generator as follows and a photoresist composition including the same.

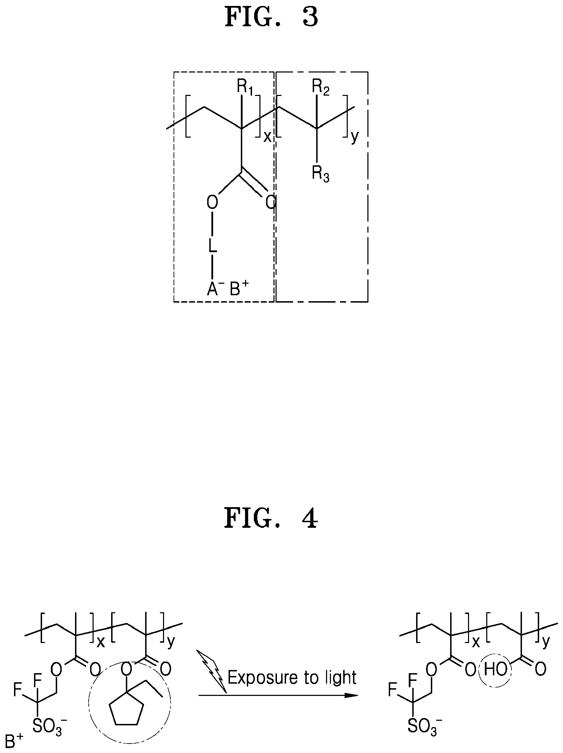

FIG. 3 represents a chemical structure of a photoacid generator according to an embodiment.

A photoacid generator according to an embodiment may include a copolymer of a monomer that generates an acid upon exposure to light and an acid-labile monomer of which solubility with respect to a developing solvent is changed by decomposition by an acid, wherein the copolymer is represented by Formula 1: 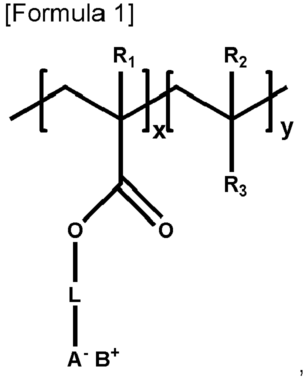 wherein
a molar ratio of x and y is 1: 1 to 1: 5, and a number average molecular weight (Mn) of the copolymer is 500 g/mol to 5,000 g/mol,
L is a single bond or a substituted or unsubstituted C1-C20 alkyl group,
A⁻ is a sulfonic acid anion or a carboxylic acid anion,
B⁺ is a sulfonium-based cation that is unsubstituted or substituted with a halogen atom or a C1-C20 haloalkyl group, or an iodonium-based cation that is unsubstituted or substituted with a halogen atom or a C1-C20 haloalkyl group,
R₁ and R₂ are each independently a hydrogen atom, a halogen atom, or a substituted or unsubstituted C1-C10 alkyl group,
R₃ is one of groups represented by Formulae 1-1 and 1-2:

   [Formula 1-1] *-C(=O)O(L₁)ₙRₐ

   [Formula 1-2] *-OR_{b},

   wherein, in Formulae 1-1 and 1-2,
L₁ is a C1-C10 alkylene group that is unsubstituted or substituted with a C1-C5 alkyl group,
n is an integer of 0 to 10 or an integer of 0 to 5,
Rₐ is a substituted or unsubstituted C4-C20 t-alkyl group, a substituted or unsubstituted C3-C50 aliphatic cyclic group, a substituted or unsubstituted C3-C60 heteroaliphatic cyclic group, substituted or unsubstituted C3-C60 heteroaromatic cyclic group, or -OC(=O)ORₐ₁, wherein Rₐ₁ is a C1-C10 alkyl group,
R_{b} is -Si(R_{b1})(R_{b2})(R_{b3}) or -C(R_{b4})(R_{b5})O(R_{b6}), wherein R_{b1}, R_{b2}, R_{b3}, R_{b4}, R_{b5}, and R_{b6} are each independently a hydrogen atom, a C1-C10 alkyl group, or a C6-C20 aryl group, and
* is a binding site.

Referring to FIG. 3, the copolymer represented by Formula 1 consists of a monomer that generates an acid upon exposure to light (left box) and an acid-labile monomer (right box).

A molar ratio of a repeating unit x of the monomer that generates an acid upon exposure to light (left box) and a repeating unit y of the acid-labile monomer (right box) may be 1:1 to 1:5, for example, 1:1 to 1:4.5, 1:1 to 1:4, 1:1 to 1:3.5, or 1:1 to 1:3. An amount of the photoacid generator may be sufficiently maintained within the molar ratio range of x and y, and a decrease in an acid yield may be prevented.

A number average molecular weight (Mn) may be 500 g/mol to 5,000 g/mol, for example, 500 g/mol to 4,000 g/mol, 500 g/mol to 3,000 g/mol, or 500 g/mol to 2,000 g/mol, or 500 g/mol to 1,500 g/mol. When the number average molecular weight (Mn) is smaller or bigger than the range, a diffusion length of the acid generated from a photoacid generator becomes longer and a uniform and smooth patterning is difficult.

L may be a single bond or a substituted or unsubstituted C1-C20 alkylene group. For example, L may be a substituted or unsubstituted C1-C10 alkylene group or a substituted or unsubstituted C1-C5 alkylene group. Here, "substitution" means being substituted with a halogen atom, a C1-C10 alkyl group substituted with a halogen atom (e.g., CCF₃, CHCF₂, CH₂F, CCl₃, etc.), a hydroxy group, a nitro group, a cyano group, an amino group, an amidino group, hydrazine, hydrazone, a sulfonic acid group or a salt thereof, phosphate or a salt thereof, a C1-C10 alkyl group, a C2-C10 alkenyl group, a C2-C10 alkynyl group, a C3-C20 cycloalkyl group, a C1-C20 heterocycloalkyl group, a C6-C20 aryl group, a C6-C20 arylalkyl group, C6-C20 heteroaryl group, or a C6-C20 heteroaryl alkyl group.

An alkyl group refers to a fully saturated and branched or un-branched (or straight or linear) hydrocarbon group. Non-limiting examples of an alkyl group are groups of methyl, ethyl, n-propyl, isopropyl, n-butyl, isobutyl, sec-butyl, n-pentyl, isopentyl, neopentyl, iso-amyl, n-hexyl, 3- methylhexyl, 2,2-dimethylpentyl, 2,3-dimethylpentyl, n-heptyl, and the like. One or more hydrogen atoms of the alkyl group may be substituted with the above-described substituent.

An alkenyl group indicates an aliphatic hydrocarbon including one or more double bonds. An alkynyl group indicates an aliphatic hydrocarbon including one or more triple bonds.

A cycloalkyl group indicates an aliphatic hydrocarbon including one or more rings. At this time, the alkyl group is as described above.

A heterocycloalkyl group indicates a cycloalkyl group including one or more hetero atoms selected from N, O, P, and S. At this time, the cycloalkyl group is as described above.

An aryl group indicates aromatic hydrocarbons including one or more rings and is used alone or in combinations. An aryl group also includes a group wherein an aromatic ring is fused with one or more cycloalkyl rings. Non-limiting examples of the aryl group include a phenyl group, a naphthyl group, and a tetrahydronaphthyl group. One or more hydrogen atoms in the aryl group may be substituted with the same substituents as in the case of the above-described alkyl group.

An arylalkyl group indicates an alkyl group-aryl group, wherein the alkyl and aryl groups are as described above.

A heteroaryl group refers to a monocyclic or bicyclic organic compound which contains one or more heteroatoms selected from N, O, P and S, and the remaining ring atom is carbon. The heteroaryl group may include, for example, 1 to 5 heteroatoms, and may include 5 to10 ring members. S or N may be oxidized to have various oxidation states. A monocyclic heteroaryl group includes, for example, a thienyl group, a furyl group, a pyrrolyl group, an imidazolyl group, a pyrazolyl group, a thiazolyl groups, an isothiazolyl group, a 1,2,3-oxadiazolyl group, a 1,2,4-oxadiazolyl group, a 1,2,5-oxadiazolyl group, a 1,3,4-oxadiazolyl group, a 1,2,3-thiadiazolyl group, a 1,2,4-thiadiazolyl group, a 1,2,5-thiaidiazolyl group, a 1,3,4-thiaidiazolyl group, an isothiazol-3-yl group, an isothiazol-4-yl group, an isothiazol-5-yl group, an oxazole-2-yl group, an oxazole-4-yl group, an oxazole-5-yl group, an isoxazole-3-yl group, an isoxazole-4-yl group, an isoxazole-5-yl group, a 1,2,4-triazole-3-yl group, a 1,2,4-triazole-5-yl group, a 1,2,3-triazol-4-yl group, a 1,2,3-triazol-5-yl group, a tetrazolyl group, a pyrid-2-yl group, a pyrid-3-yl group, a 2-pyrazine-2-yl group, a pyrazine-4-yl group, a pyrazine-5-yl group, a 2-pyrimidine-2-yl group, a 4-pyrimidine-2-yl group, or a 5-pyrimidine-2-yl group. The term "heteroaryl" includes cases in which a heteroaromatic ring is fused to one or more aryl groups, cycloaliphatic groups, or heterocycles. Examples of bicyclic heteroaryl include indolyl, isoindolyl, indazolyl, indolizinyl, purinyl, quinolizinyl, quinolinyl, isoquinolinyl, and the like. One or more hydrogen atoms in the heteroaryl group may be substituted with the same substituents as in the case of the above-described alkyl group.

A heteroarylalkyl group indicates an alkyl group-heteroaryl group, wherein the aryl groups are as described above. A heteroaryloxy group indicates a heteroaryl-O-group, wherein the heteroaryl groups are as described above.

A⁻ may be a sulfonic acid anion or a carboxylic acid anion. For example, A⁻ may be a sulfonic acid anion.

B⁺ may be, as a counter cation, a sulfonium-based cation that is unsubstituted or substituted with a halogen atom or a C1-C20 haloalkyl group, or an iodonium-based cation that is unsubstituted or substituted with a halogen atom or a C1-C20 haloalkyl group. A halogen atom is -F, -CI, -Br, or -I. A C1-C20 haloalkyl group indicates a group wherein one or more hydrogen atoms in an alkyl group is substituted with a halogen atom, and is, for example, -CF₃, -CCl₃, or -CF₂CF₃, and the like. A counter cation B⁺ substituted with a halogen atom or a haloalkyl group has a decreased pKa and acts as a strong acid, and the sensitivity to an exposure to extreme ultraviolet (EUV) radiation having a wavelength of 13.5 nm may be further increased.

In exemplary embodiments, B⁺ may include a sulfonium-based cation represented by Formula 2 or an iodonium-based cation represented by Formula 3: 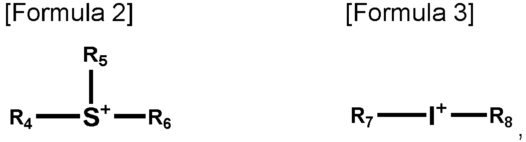 wherein, in Formulae 2 and 3,
at least two of R₄, R₅ and R₆ are bonded to each other to form, together with a sulfur atom, a ring which is unsubstituted or substituted with at least one halogen atom or a C1-C20 haloalkyl group, or R₄, R₅ and R₆ are each independently a substituted or unsubstituted C6-C60 aryl group,
R₇ and R₈ are each independently a substituted or unsubstituted C6-C60 aryl group or a substituted or unsubstituted C6-C60 heteroaryl group.

Examples of the core of the ring unsubstituted or substituted with at least one halogen atom or a C1-C20 haloalkyl group formed by, together with a sulfur atom, bonding at least two of R₄, R₅, and R₆ include a thioxanthene-based ring, a thioxanthone-based ring, a benzothiophene-based ring, or a dibenzothiophene-based ring, but are not limited thereto.

In exemplary embodiments, B⁺ may include a triphenylsulfonium-based cation that is unsubstituted or substituted with at least one halogen atom or a C1-C20 haloalkyl group, a thioxanthone-based cation that is unsubstituted or substituted with at least one halogen atom or a C1-C20 haloalkyl group, or a diphenyliodonium-based cation that is unsubstituted or substituted with at least one halogen atom or a C1-C20 haloalkyl group.

In exemplary embodiments, B⁺ may include one of sulfonium-based cations or iodonium-based cations represented by Formulae 3-1 to 3-15: 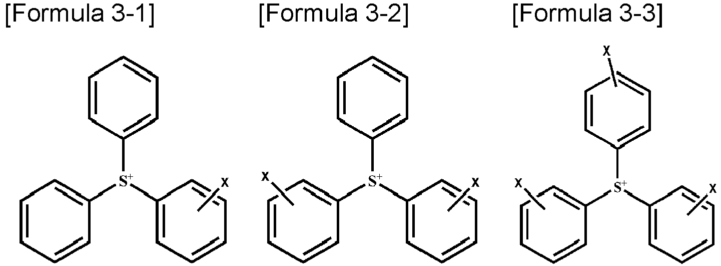 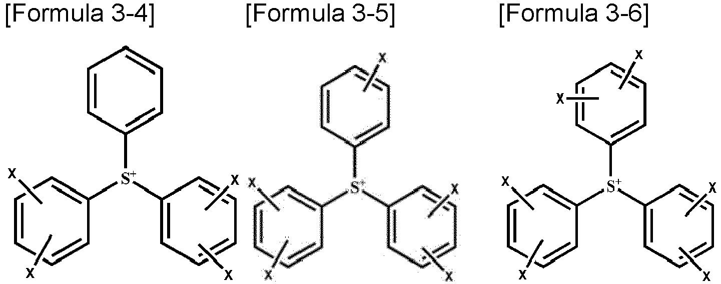 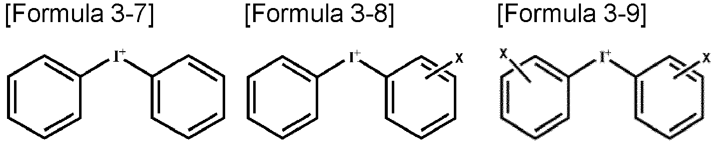 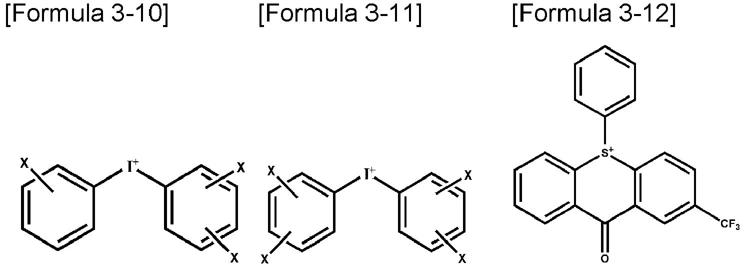 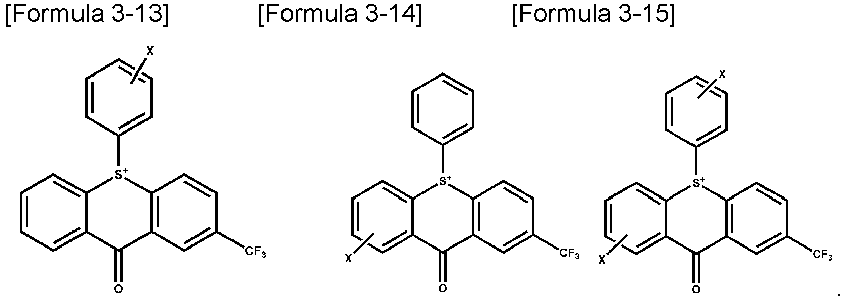 wherein, in Formulae 3-1 to 3-15,
X is a halogen atom.
R₁ and R₂ may each independently be a hydrogen atom, a halogen atom, or a substituted or unsubstituted C1-C10 alkyl group. For example, R₁ and R₂ may each independently be a hydrogen atom or a substituted or unsubstituted C1-C10 alkyl group. Here, "substitution" may be substituted in the same manner as in the above-described case of a substituent.
R₃ may be one of groups represented by Formulae 1-1 and 1-2:

   [Formula 1-1] *-C(=O)O(L₁)ₙRₐ

   [Formula 1-2] *-OR_{b},

   wherein, in Formulae 1-1 and 1-2,
L₁ is a C1-C10 alkylene group that is unsubstituted or substituted with a C1-C5 alkyl group.
n is an integer of 0 to 10 or an integer of 0 to 5,
Rₐ is a substituted or unsubstituted C4-C20 t-alkyl group, a substituted or unsubstituted C3-C50 aliphatic cyclic group, a substituted or unsubstituted C3-C60 heteroaliphatic cyclic group, a substituted or unsubstituted C3-C60 heteroaromatic cyclic group, or -OC(=O)ORₐ₁, wherein Rₐ₁ is a C1-C10 alkyl group,
R_{b} is -Si(R_{b1})(R_{b2})(R_{b3}) or -C(R_{b4})(R_{b5})O(R_{b6}), wherein R_{b1}, R_{b2}, R_{b3}, R_{b4}, R_{b5}, and R_{b6} are each independently a hydrogen atom, a C1-C10 alkyl group, or a C6-C20 aryl group, and
* is a binding site.

An alkylene group refers to a group in which a hydrogen atom is missing at the carbon atoms at both ends of alkane (CₙH₂ₙ). Non-limiting examples of the alkylene group include a methylene group, an ethylene group, a propylene group, a butylene group, or a pentylene group. Here, "substitution" may be conducted in the same manner as in the above-described case of a substituent.

An aliphatic cyclic group may be a monocyclic or polycyclic aliphatic cyclic group. Examples of the monocyclic aliphatic cyclic groups may include a cyclopentyl group, a cyclohexyl group, or a cyclooctyl group, and the like. Examples of the polycyclic aliphatic cyclic group include a norbornyl group, a norbonenyl group, a tricyclodecanyl group, or a tetracyclodecanyl group and the like. A hetero aliphatic cyclic group is a cyclic element that forms the aliphatic cyclic group and may be an aliphatic cyclic group including one or more hetero atoms selected from N, O, P, and S and the remaining ring atom is C. Here, "substitution" may be substituted in the same manner as in the above-described case of a substituent.

An aromatic cyclic group may be a monocyclic or polycyclic aromatic cyclic group. Examples of the monocyclic aromatic cyclic group include a benzene ring. Examples of the polycyclic aromatic cyclic group include a naphthalene ring, phenanthrene ring, anthracene ring, or fluorene ring, and the like. A hetero aromatic cyclic group may be an aromatic cyclic group that includes, as a ring element forming the aromatic cyclic group, one or more hetero atoms selected from N, O, P, and S, and, as the other ring atom, C. Here, "substitution" may be substituted in the same manner as in the above-described case of a substituent.

In exemplary embodiments, R₃ may include one of substituents represented by Formulae 4-1 to 4-10: 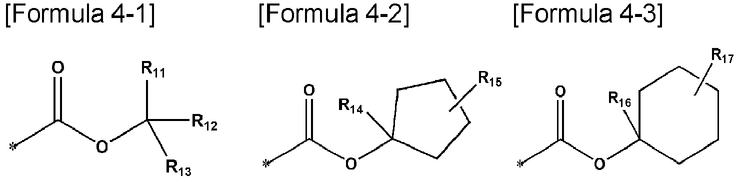 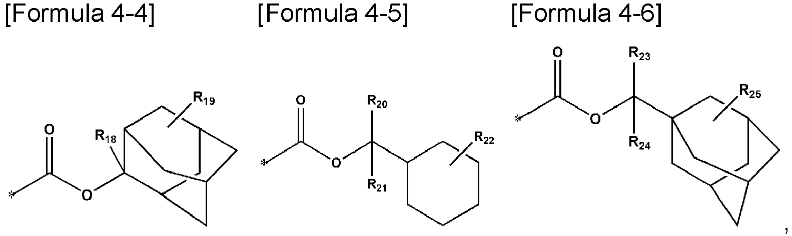 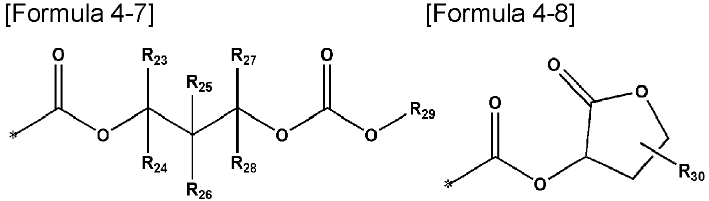 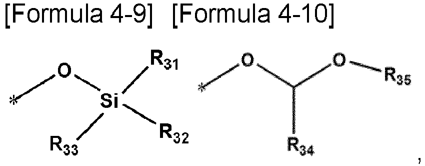 wherein, in Formulae 4-1 to 4-10,
R₁₁, R₁₂, R₁₃, R₁₄, R₁₆, R₁₈, R₂₉, R₃₁, R₃₂, R₃₃, and R₃₅ are each independently a C1-C5 alkyl group or a C6-C20 aryl group,
R₁₅, R₁₇, R₁₉, R₂₀, R₂₁, R₂₂, R₂₃, R₂₄, R₂₅, R₂₆, R₂₇, R₂₈, R₃₀, and R₃₄ are each independently a hydrogen atom or a C1-C5 alkyl group, and
* is a binding site.

A polydispersity index (Mw/Mn, PDI) of the copolymer may be 1.0 to 3.0.

In exemplary embodiments, the copolymer may include a copolymer represented by Formula 5: 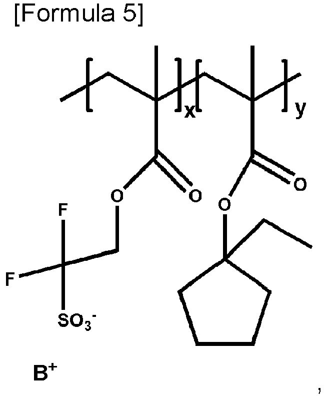 wherein, in Formula 5,
a molar ratio of x and y is 1: 1 to 1: 5, and a number average molecular weight (Mn) is 500 g/mol to 5,000 g/mol,
B⁺ is a triphenylsulfonium cation substituted with at least one halogen atom, a thioxanthone cation substituted with at least one halogen atom or a C1-C10 haloalkyl group, or a diphenyliodonium which is unsubstituted or substituted with at least one halogen atom.

FIG. 4 represents a photoacid generator according to an embodiment having a chemical structure of which solubility differs before and after exposure to light.

Referring to FIG. 4, before exposure to light, i.e., in an unexposed region, a photoacid generator according to an embodiment is hydrophobic and insoluble in a developing solvent, however, after exposure, i.e., in an exposed region, a protective group of 1-ethylcyclopentyloxy is deprotected into -OH and thus the photoacid generator becomes hydrophilic and soluble in the developing solvent. As a result, the miscibility of the photoacid generator with respect to a base polymer may be improved and thus, a diffusion length of the acid generated from the photoacid generator may be reduced, and an amount of the photoacid generator may be increased to improve an acid yield.

The exposure may be made using high-energy rays. For example, the exposure may be made using KrF eximer laser having a wavelength of 248 nm, ArF eximer laser having a wavelength of 193 nm, or extreme ultraviolet (EUV) radiation having a wavelength of 13.5 nm. For example, the exposure may be made using extreme ultraviolet (EUV) radiation having a wavelength of 13.5 nm.

A photoresist composition according to another embodiment may include the photoacid generator, a base polymer, a photo-decomposable quencher (PDQ), and a solvent.

Due to the inclusion of the photoacid generator, the photoresist composition includes and may have a reduced acid diffusion length in a photoresist film, and a similar or improved acid yield.

An amount of the copolymer of the photoacid generator may be 5 parts by weight to 70 parts by weight, 10 parts by weight to 60 parts by weight, or 10 parts by weight to 50 parts by weight, with respect to 100 parts by weight of the base polymer. When an amount of the copolymer of the photoacid generator is less than 5 parts by weight, as the number of photons of high-energy rays such as extreme ultraviolet (EUV) light is few, a light absorption rate may be lowered. When an amount of the copolymer of the photoacid generator is more than 70 parts by weight, T_{g} of the base polymer may change, and the resolution of resist patterns formed by a remaining photoacid generator in the lithography process by a high-energy ray light source may be deteriorated.

In exemplary embodiments, the base polymer is a copolymer including a hydroxystyrene monomer and a monomer having an acid degradable protective group, wherein the monomer having the acid degradable protective group may include one of substituents represented by Formulae 4-1 to 4-10: 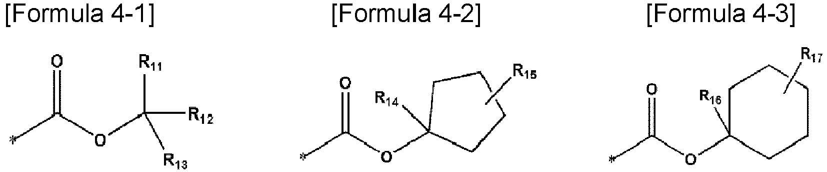 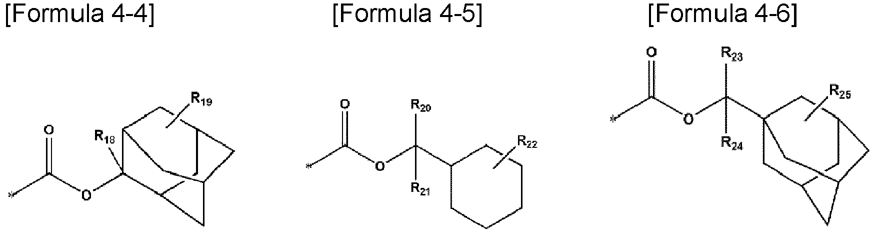 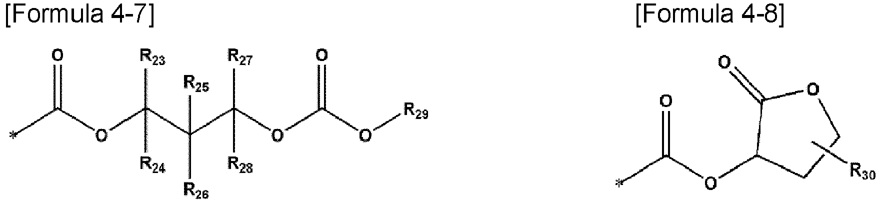 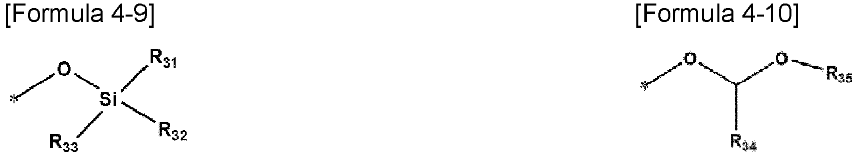 wherein, in Formulae 4-1 to 4-10,
R₁₁, R₁₂, R₁₃, R₁₄, R₁₆, R₁₈, R₂₉, R₃₁, R₃₂, R₃₃, and R₃₅ may each independently be a C1-C5 alkyl group or a C6-C20 aryl group,
R₁₅, R₁₇, R₁₉, R₂₀, R₂₁, R₂₂, R₂₃, R₂₄, R₂₅, R₂₆, R₂₇, R₂₈, R₃₀, and R₃₄ may each independently be a hydrogen atom or a C1-C5 alkyl group, and,
* is a binding site.

In exemplary embodiments, the base polymer may include a polymer represented by Formula 6: 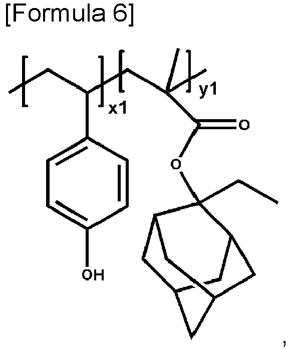 wherein in Formula 6,
a molar ratio of x1 and y1 may be 1:1 to 1:5, for example, a molar ratio of x1 and y1 may be 1:1 to 1:4 or 1:1 to 1:3. A number average molecular weight (Mn) may be 500 g/mol to 5,000 g/mol.

For example, x1 may be an integer of 1 to 100 and y1 may be an integer of 1 to 100; or x1 may be an integer of 1 to 50 and y1 may be an integer of 1 to 50; or x1 may be an integer of 1 to 30 and y1 may be an integer of 1 to 30.

A polydispersity index (Mw/Mn, PDI) of the polymer may be 1.0 to 3.0.

In exemplary embodiments, the base polymer is a copolymerized structure in which a hydroxystyrene monomer and a monomer having an adamantyl group as an acid degradable protective group are copolymerized. However, the base polymer is not limited thereto, and all base polymers used in the art may be used.

An amount of the base polymer in the photoresist composition may be about 1 part by weight to about 25 parts by weight or about 1 part by weight to about 20 parts by weight, with respect to 100 parts by weight of the entire photoresist composition. When an amount of the base polymer is less than about 1 part by weight, the photoresist composition may not be coated easily. When an amount of the base polymer is more than about 25 parts by weight, a viscosity of the photoresist composition becomes excessively large and a uniform coating of the photoresist composition may be difficult.

In exemplary embodiments, the photo-decomposable quencher may include a quencher represented by Formula 7:

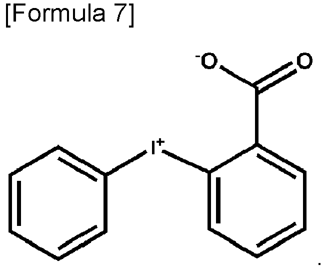

Alternatively, the photo-decomposable quencher may include a quencher represented by Formula 8: However, the photo-decomposable quencher is not limited thereto, and all photo-decomposable quenchers used in the art may be used.

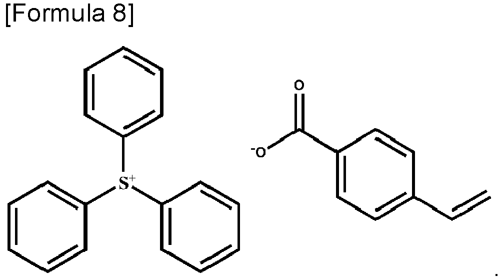

An amount of the photo-decomposable quencher in the photoresist composition may be 0.1 parts by weight to 20 parts by weight or 0.5 parts by weight to 5 parts by weight, with respect to 100 parts by weight of the base polymer, but is not limited thereto.

In exemplary embodiments, the solvent may include polypropylene glycol monomethyl ether acetate, propylene glycol monomethyl ether, or a combination thereof. However, the solvent is not limited thereto, and all solvents used in the art may be used.

The composition may be a chemically amplified photoresist composition.

A diffusion length of the acid generated by the photoacid generator in a resist film may be controlled in the range of 0.01 nm to 10 nm. For example, the acid diffusion length may be controlled to be in the range of 0.01 nm to 9 nm, 0.01 nm to 8 nm, 0.01 nm to 7 nm, 0.01 nm to 6 nm, 0.01 nm to 5.5 nm, or 0.01 nm to 5.1 nm.

A manufacturing method of a photoacid generator according to another embodiment includes: copolymerizing, by free radical polymerization, a monomer that generates an acid upon exposure to light and an acid-labile monomer of which solubility with respect to a developing solvent is changed by decomposition by an acid; and substituting a counter cation of the acid-generating monomer with a sulfonium-based cation substituted with a halogen atom or a C1-C20 haloalkyl group or an iodonium-based cation that is unsubstituted or substituted with a halogen atom or a C1-C20 haloalkyl group.

Since the copolymerization in the manufacturing method of the photoacid generator is achieved by free radical polymerization, the manufactured copolymer may have a wide range of polydispersity index (Mw/Mn, PDI).

A method of forming a pattern according to another embodiment may include: forming a photoresist film by applying a photoresist composition on aboard; exposing at least a portion of the photoresist film with high-energy rays; and developing the exposed photoresist film by using a developing solution.

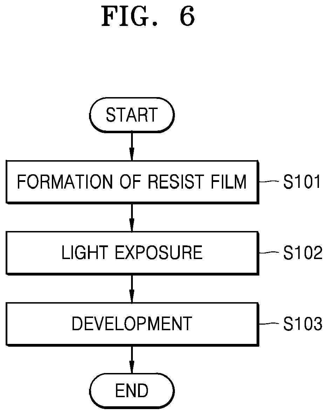

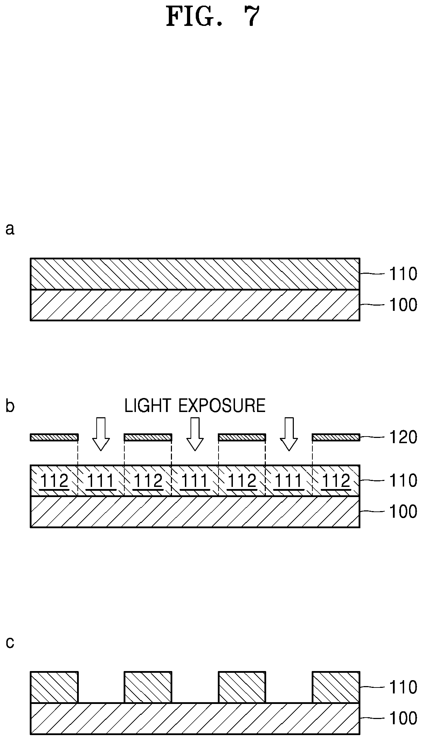

Hereinafter, the method according to an embodiment will be described in more detail by referring to FIGS. 6 and 7. FIG. 6 is a flowchart representing a pattern forming method according to an embodiment, and FIG. 7 is a side cross-sectional view illustrating a pattern forming method according to an embodiment. Hereinafter, a method of forming a pattern by using a positive photoresist composition will be described in detail as an example, but embodiments are not limited thereto.

Referring to FIG. 6, the method of forming a pattern includes: forming a photoresist film by applying a photoresist composition (S101); exposing at least a portion of the photoresist film with high-energy rays (S102); and developing the exposed photoresist film by using a developing solution (S103). The steps above may be omitted as necessary, or may be performed in different orders.

First, a board 100 is prepared. The board 100 may be, for example, a semiconductor board, such as a silicon board or a germanium board, or may be formed of glass, quartz, ceramic, copper, and the like. In an embodiment, the board 100 may include a Group III-V compound, such as GaP, GaAs, GaSb, and the like.

A photoresist film 110 may be formed by coating the board 100 with a photoresist composition to a desired thickness according to a coating method. As needed, a heating process may be performed thereon to remove an organic solvent remaining in the photoresist film 110. The coating method may include spin coating, dipping, roller coating, or other common coating methods. Among these methods, spin coating may be particularly used, and the photoresist film 110 having a desired thickness may be formed by adjusting the viscosity, concentration, and/or spin speed of the photoresist composition. In an embodiment, a thickness of the photoresist film 110 may be in a range of about 10 nm to about 300 nm. In one or more embodiments, a thickness of the photoresist film 110 may be in a range of about 30 nm to about 200 nm.

The lower limit of a pre-baking temperature may be about 60 °C or higher, for example, about 80 °C or higher. In addition, the upper limit of a pre-baking temperature may be about 150 °C or lower, for example, about 140 °C or lower. The lower limit of a pre-baking time may be about 5 seconds or more, for example, about 10 seconds or more. The upper limit of a pre-baking time may be about 600 seconds or less, for example, about 300 seconds or less.

Before coating the board 100 with the photoresist composition, a film to be etched (not shown) may be further formed on the board 100. The film to be etched may refer to a layer in which an image is transferred from a photoresist pattern and converted into a predetermined pattern. In an embodiment, the film to be etched may be formed to include, for example, an insulating material, such as silicon oxide, silicon nitride, or silicon oxynitride. In one or more embodiments, the film to be etched may be formed to include a conductive material, such as metal, metal nitride, metal silicide, or metal silicide nitride. In one or more embodiments, the film to be etched may be formed to include a semiconductor material, such as polysilicon.

In an embodiment, an antireflection layer may be further formed on the board100 to exhibit efficiency of the photoresist at most. The antireflection layer may be an organic-based antireflection layer or an inorganic-based antireflection layer.

In an embodiment, a protective layer may be further provided on the photoresist film 110 to reduce the influence of alkaline impurities included in the process. In addition, when performing immersion exposure, for example, a protective film against immersion may be provided on the photoresist film 110 to avoid direct contact between an immersion medium and the photoresist film 110.

Next, at least a portion of the photoresist film 110 may be exposed with high-energy rays. For example, high-energy rays passing through a mask 120 may be irradiated to at least a portion of the photoresist film 110. Accordingly, the photoresist film 110 may have an exposed area 111 and an unexposed area 112.

The exposure may be carried out by irradiating high-energy rays through a mask having a predetermined pattern and by using liquid, such as water or the like, as a medium in some cases. Examples of the high-energy rays are electromagnetic waves, such as ultraviolet rays, far-ultraviolet rays, extreme ultraviolet rays (EUV rays, wavelength of 13.5 nm), X-rays, γ-rays, and the like; charged particle beams, such as electron beams (EBs), α rays, and the like; and the like. The irradiation of such high-energy rays may be collectively referred to as "exposure".

For use as a light source of the exposure, various types of irradiation including irradiating laser beams in the ultraviolet region, such as KrF excimer laser (wavelength of 248 nm), ArF excimer laser (wavelength of 193 nm), and an F₂ excimer laser (wavelength of 157 nm), irradiating harmonic laser beams in the far ultraviolet or vacuum ultraviolet region by a wavelength conversion method using laser beams from a solid-state laser source (e.g., YAG or semiconductor laser), irradiating electron beams or EUV rays, or the like may be used. Upon the exposure, the exposure may be performed through a mask corresponding to a desired pattern. However, when the light source of the exposure is electron beams, the exposure may be performed by direct drawing without using a mask.

The integral dose of the high-energy rays may be less than or equal to about 2,000 mJ/cm², for example, less than or equal to about 500 mJ/cm², in the case of using EUV rays as the high-energy rays. In addition, in the case of using electron beams as the high-energy rays, the integral dose of the high-energy rays may be less than or equal to about 5,000 µC/cm², for example, less than or equal to about 1,000 µC/cm².

In addition, post-exposure baking (PEB) may be performed after the exposure. The lower limit of a PEB temperature may be about 50 °C or higher, for example, about 80 °C or higher. The upper limit of a PEB temperature may be about 180 °C or less, for example, about 130 °C or less. The lower limit of a PEB time may be about 5 seconds or more, for example, about 10 seconds or more. The upper limit of a PEB time may be about 600 seconds or less, for example, about 300 seconds or less.

Next, the exposed photoresist film 110 may be developed by using a developing solution. The exposed area 111 may be washed away by the developing solution, whereas the unexposed area 112 may remain without being washed away by the developing solution.

For use as the developing solution, an alkali developing solution, a developing solution containing an organic solvent (hereinafter also referred to as "organic developing solution"), and the like may be used. As a developing method, a dipping method, a puddle method, a spray method, a dynamic administration method, and the like may be used. The developing temperature may be, for example, about 5 °C or more and about 60°C or less, and the developing time may be, for example, about 5 seconds or more and about 300 seconds or less.

The alkali developing solution may be, for example, an alkaline aqueous solution which dissolves at least one alkaline compound, such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethyl ammonium hydroxide (TMAH), pyrrole, piperidine, choline, 1,8-diazabicyclo[5.4.0]-7-undecene (DBU), 1,5-diazabicyclo[4.3.0]-5-nonene, and the like. The alkaline developing solution may further include a surfactant.

The lower limit of the amount of the alkaline compound in the alkaline developing solution may be about 0.1 mass% or more, for example, about 0.5 mass% or more, and for example, about 1 mass% or more. In addition, the upper limit of the amount of the alkaline compound in the alkaline developing solution may be about 20 mass% or less, for example, about 10 mass% or less, and for example, about 5 mass% or less.

After the development, a resulting photoresist pattern may be washed with ultrapure water, and subsequently, the water remaining on the board 100 and the pattern may be removed.

As an organic solvent contained in the organic developing solution, for example, an alcohol-based solvent, an ether-based solvent, a ketone-based solvent, an amide-based solvent, an ester-based solvent, a sulfoxide-based solvent, a hydrocarbon-based solvent, and the like may be used.

In detail, examples of the alcohol-based solvent are: a monoalcohol-based solvent, such as methanol, ethanol, n-propanol, isopropanol, 1-methoxy-2-propanol, 1-ethoxy-2-propanol, n-butanol, isobutanol, sec-butanol, tert-butanol, n-pentanol, isopentanol, 2-methylbutanol, sec-pentanol, tert-pentanol, 3-methoxybutanol, 3-methyl-3-methoxybutanol, n-hexanol, 2 -methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sectetradecyl alcohol, sec-heptadecyl alcohol, furfuryl alcohol, phenol, cyclohexanol, methylcyclohexanol, 3,3,5-trimethylcyclohexanol, benzyl alcohol, diacetone alcohol, and the like; a polyhydric alcohol-based solvent, such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and the like; a polyhydric alcohol-containing ether-based solvent, such as ethyleneglycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, diethylene glycol dimethyl ether, propylene glycol monomethyl ether, propylene glycol dimethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, and the like; and the like.

Examples of the ether-based solvent are: a dialkyl ether-based solvent, such as diethyl ether, dipropyl ether, dibutyl ether, and the like; a cyclic ether-based solvent, such as tetrahydrofuran, tetrahydropyran, and the like; an aromatic ring-containing ether-based solvent, such as diphenyl ether, anisole, and the like; and the like.

Examples of the ketone-based solvent are: a chain ketone-based solvent, such as acetone, methylethyl ketone, methyl-n-propyl ketone, methyl-n-butyl ketone, methyl-n-pentyl ketone, diethyl ketone, methyl isobutyl ketone, 2-heptanone, ethyl-n-butyl ketone, methyl-n-hexyl ketone, diisobutyl ketone, trimethylnonanone, and the like; a cyclic ketone solvent, such as cyclopentanone, cyclohexanone, cycloheptanone, cyclooctanone, methylcyclohexanone, and the like; 2,4-pentanedione; acetonylacetone; acetphenone; and the like.

Examples of the amide-based solvent are: a cyclic amide-based solvent, such as N,N'-dimethylimidazolidinone, N-methyl-2-pyrrolidone, and the like; a chain amide-based solvent, such as N-methylformamide, N,N-dimethylformamide, N,N-diethylformamide, acetamide, N-methylacetamide, N,N-dimethylacetamide, N-methylpropionamide, and the like; and the like.

Examples of the ester-based solvent are: an acetate ester-based solvent, such as methyl acetate, ethyl acetate, n-propyl acetate, isopropyl acetate, n-butyl acetate, isobutyl acetate, sec-butyl acetate, t-butyl acetate, n-pentyl acetate, isopentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, and the like; a polyhydric alcohol-containing ether carboxylate-based solvent, such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, and the like; a lactone-based solvent, such as γ-butylolactone, δ-valerolactone, and the like; a carbonate-based solvent, such as dimethyl carbonate, diethyl carbonate, ethylene carbonate, propylene carbonate, and the like; a lactate ester-based solvent, such as methyl lactate, ethyl lactate, n-butyl lactate, n-amyl lactate, and the like; glycoldiacetate, methoxytriglycol acetate, propionic acid ethyl, propionic acid n-butyl, propionic acid isoamyl, diethyloxalate, di-n-butyloxalate, methyl acetoacetate, ethyl acetoacetate, malonic acid diethyl, phthalic acid dimethyl, phthalic diethyl, and the like.

Examples of the sulfoxide-based solvent are dimethyl sulfoxide, diethyl sulfoxide, and the like.

Examples of the hydrocarbon-based solvent are: an aliphatic hydrocarbon-based solvent, such as n-pentane, isopentane, n-hexane, isohexane, n-heptane, isoheptane, 2,2,4-trimethyl pentane, n-octane, isooctane, cyclohexane, methylcyclohexane, and the like; an aromatic hydrocarbon-based solvent, such as benzene, toluene, xylene, mesitylene, ethyl benzene, trimethyl benzene, methylethyl benzene, n-propyl benzene, isopropyl benzene, diethyl benzene, isobutyl benzene, triethyl benzene, diisopropyl benzene, n-amylnaphthalene, and the like.

In an embodiment, the organic solvent may be selected from an alcohol-based solvent, an amide-based solvent, an ester-based solvent, a sulfoxide-based solvent, and any combination thereof. In one or more embodiments, the organic solvent may be selected from propylene glycol monomethyl ether, propylene glycol monoethyl ether, propylene glycol monomethyl ether acetate, N-methyl-2-pyrrolidone, N,N-dimethylacetamide, ethyl lactate, dimethyl sulfoxide, and any combination thereof.

In an embodiment, when an acetal-type acid labile group is used, the organic solvent may further include alcohol having a high boiling point, such as diethylene glycol, propylene glycol, glycerol, 1,4-butanediol, or 1,3-butanediol, to accelerate a deprotection reaction of acetal.

The lower limit of the amount of the organic solvent in the organic developing solution may be about 80 mass % or more, for example, about 90 mass % or more, and for example, about 95 mass % or more, and for example, about 99 mass % or more.

The organic developing solution may also include a surfactant. In addition, the organic developing solution may include a trace amount of moisture. In addition, upon the development, the solvent may be substituted with a solvent of a different kind from the organic developing solution to stop the development.

The photoresist pattern resulting from the development may be further washed. As a washing solution, ultrapure water, a liquid rinse, and the like may be used. The liquid rinse is not particularly limited as long as it does not dissolve the photoresist pattern, and a solution containing a general organic solvent may be used. For example, the liquid rinse may be an alcohol-based solvent or an ester-based solvent. After the washing, the liquid rinse remaining on the pattern may be removed.

In addition, the developing solution may be used either individually or in a combination of two or more.

After the photoresist pattern is formed as described above, an etching process may be performed thereon to obtain a patterned wiring board. The etching method may be performed by known methods including: dry etching using plasma gas; wet etching using an alkali solution, a cupric chloride solution, a ferric chloride solution; and the like.

After forming the resist pattern, plating may be performed. Although not particularly limited, the plating method may include, for example, copper plating, solder plating, nickel plating, gold plating, and the like.

The photoresist pattern remaining after the etching may be exfoliated with an organic solvent. Although not particularly limited, examples of the organic solvent are propylene glycol monomethyl ether acetate (PGMEA) propylene glycol monomethyl ether (PGME), ethyl lactate (EL), and the like. Although not particularly limited, examples of the exfoliation method are an immersion method, a spray method, and the like. In addition, the wiring board on which the photoresist pattern is formed may be a multilayer wiring board, and may have through holes with a small diameter.

In an embodiment, after the formation of the photoresist pattern, the wiring board may be formed by a so-called lift-off process in which metal is deposited in a vacuum and then the photoresist pattern is dissolved in a solution.

Hereinafter, embodiments and comparative examples of the present invention are described. However, the following embodiments are for an illustrative purpose only and the scope of the present disclosure is not limited thereto.

### [Examples]

### (Synthesis of photoacid generator)

Photoacid generators (PAG) 1 to 6 of Synthesis Examples 1 to 6 were synthesized according to Scheme 1:

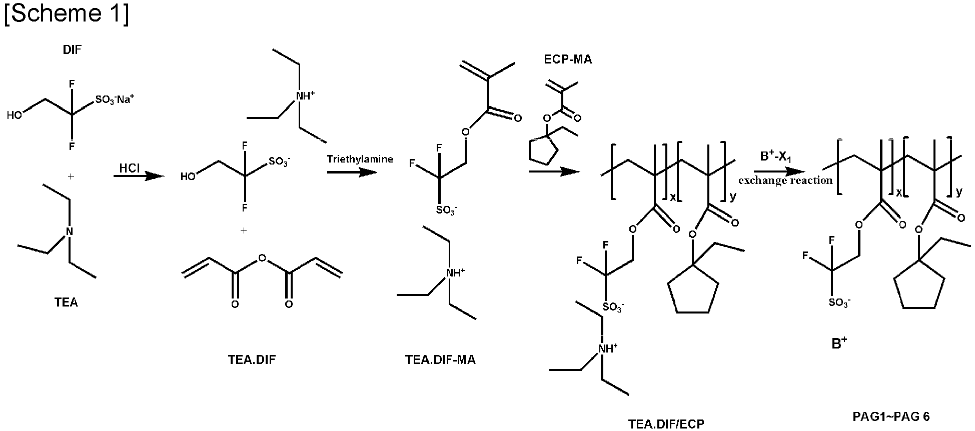

The counter cations B⁺ and X₁ used for synthesizing PAG 1 to PAG 6 are as follows:
PAG 1: 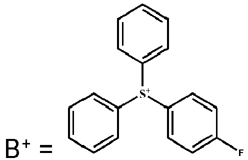 1FTPS, X₁= Br
PAG 2: 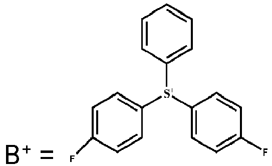 2FTPS, X₁= Br
PAG 3: 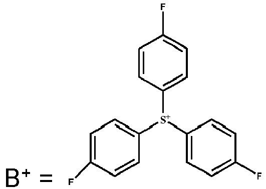 3FTPS, X₁= Br
PAG 4: 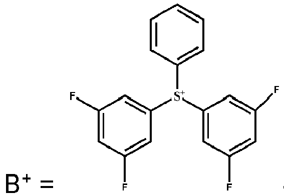 4FTPS, X₁= Cl
PAG 5: 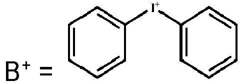 DPI, X₁= OTf(triflate, CF₃SO₃⁻)
PAG 6: 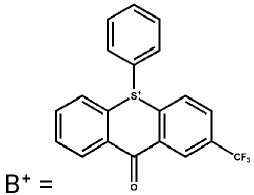 CF3f, X₁= Cl.

### Synthesis Example 1: Synthesis of PAG 1

5 g (27 mmol) of sodium 2-hydroxy-1,1-difluoroethanesulfonate (DIF) and 2.7 g (27 mmol) of triethylamine (TEA) were placed in a round-bottom flask and dispersed in 100 ml of methylene chloride to obtain a dispersion. 2.0 g (54 mmol) of HCI was slowly dropped to the dispersion, and then a reaction was carried out at room temperature for 2 hours to obtain a solution. The obtained solution was filtered through a filter paper and undissolved NaCl was removed. The filtered solution was then concentrated by an evaporator, precipitated by using ether and dried at 40 °C for 24 hours to obtain TEA.DIF which is an ionic complex of triethylamine and hydroxy-1,1-difluoroethanesulfonic acid.

5 g (19 mmol) of TEA.DIF, 5.9 g (38 mmol) of methacrylic acid anhydride, and 5.8 g (57 mmol) of triethylamine (TEA) were placed in a round-bottom flask, and a reaction was carried out at room temperature for 4 hours to obtain a reactant. The obtained reactant was precipitated with ether, unreacted methacrylic acid anhydride and triethylamine (TEA) were removed therefrom, and the reactant was dried at 40 °C for 24 hours to obtain TEA.DIF-MA.

0.58 g (1.8 mmol) of TEA.DIF-MA, 1 g (5.5 mmol) of ECP-MA, and 0.1 g (0.4 mmol) of azo initiator (V601) were placed in a vial and dissolved in solvents of 3 mL of tetrahydrofuran (THF) and 3 mL of acetonitrile (ACN) to obtain a solution. A reaction was carried out in the obtained solution at 70 °C for 4 hours and precipitated with ether to obtain a mother copolymer of TEA.DIF/ECP (x/y = 1/3, Mn = 1,300, PDI = 1.1).

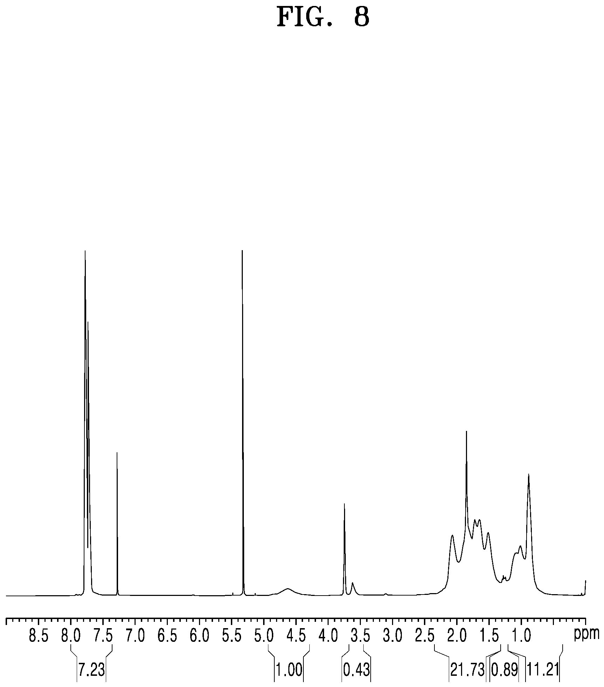

0.5 g (0.6 mmol) of a mother copolymer of TEA.DIF/ECP and 0.55 g (1.2 mmol) of 1FTPS-Br were placed in a vial, dissolved in 10 mL of methylene chloride (MC), and then 1 mL of deionized water was added to obtain a solution. The obtained solution was reacted at room temperature for 2 hours and the solvent was removed therefrom by an evaporator to obtain a reactant. The reactant was redissolved in 1 mL of tetrahydrofuran (THF), precipitated with deionized water (DW), and triethylamine (TEA) and unreacted 1FPAG-Br were removed. The precipitated polymer was dissolved in methylenechloride (MC), sodium sulfate was added thereto, followed by filtration to remove moisture therefrom. From the solution where the polymer was dissolved in methylene chloride (MC), methylene chloride (MC) was removed by an evaporator to synthesize triphenylsulfonium substituted with one fluorine (1FTPS)/ECP copolymer PAG 1. PAG 1 was confirmed by ¹H-NMR of FIG. 8.

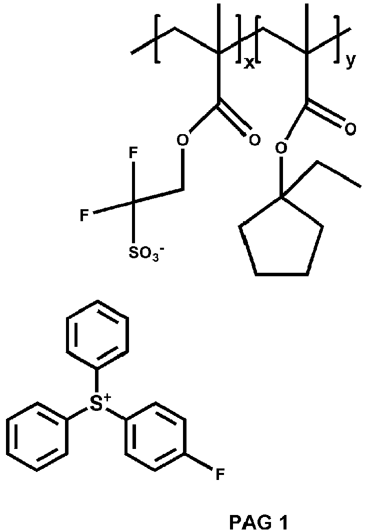

### Synthesis Example 2: Synthesis of PAG 2

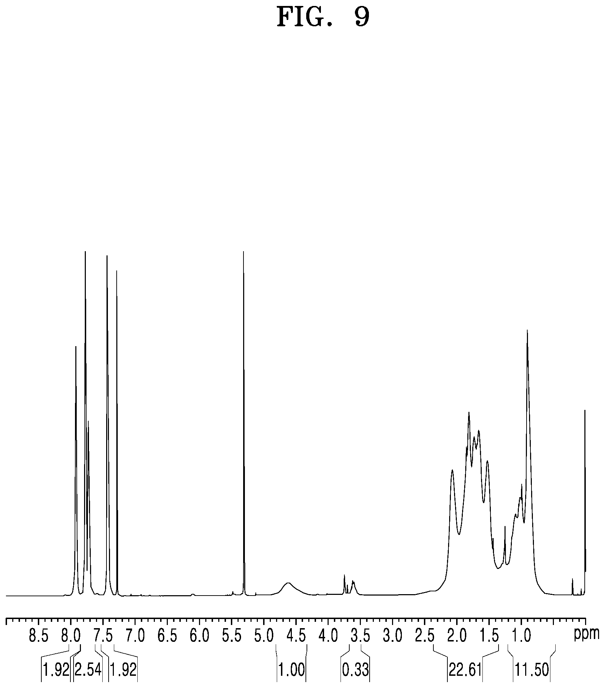

Triphenylsulfonium substituted with two fluorines (2FTPS)/ECP copolymer PAG 2 was synthesized in the same manner as in Synthesis Example 1, except that instead of 0.55 (1.2 mmol) of 1FTPS-Br, 0.55 (1.2 mmol) of 2FTPS-Br was reacted with a mother copolymer of TEA.DIF/ECP. PAG 2 was confirmed by ¹H-NMR of FIG. 9.

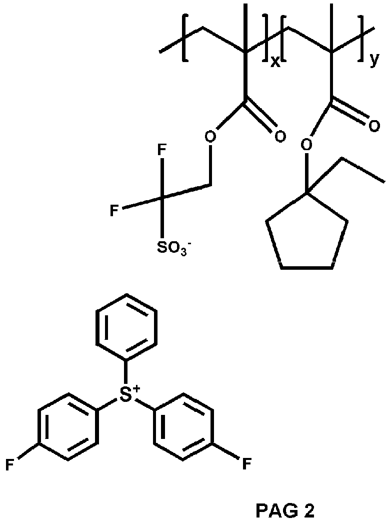

### Synthesis Example 3: Synthesis of PAG 3

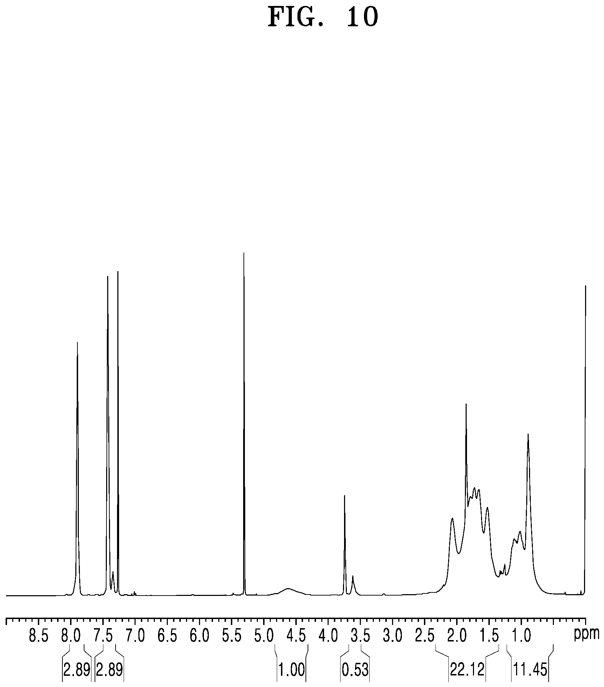

Triphenylsulfonium substituted with three fluorines (3FTPS)/ECP copolymer PAG 3 was synthesized in the same manner as in Synthesis Example 1, except that instead of 0.55 (1.2 mmol) of 1FTPS-Br, 0.55 (1.2 mmol) of 3FTPS-Br was reacted with a mother copolymer of TEA.DIF/ECP. PAG 3 was confirmed by ¹H-NMR of FIG. 10.

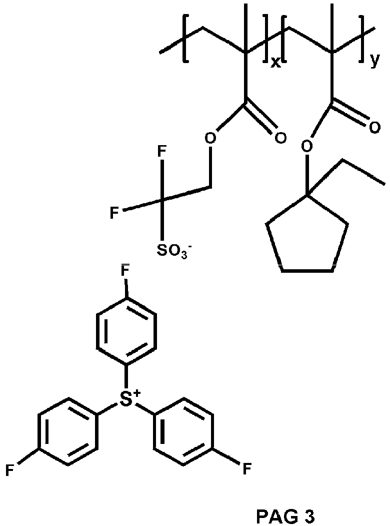

### Synthesis Example 4: Synthesis of PAG 4

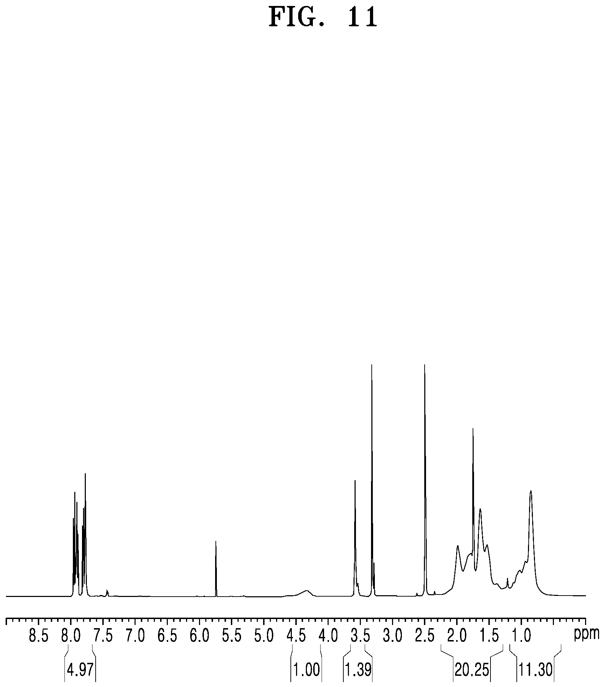

Triphenylsulfonium substituted with four fluorines (4FTPS)/ECP copolymer PAG 4 was synthesized in the same manner as in Synthesis Example 1, except that instead of 0.55 (1.2 mmol) of 1FTPS-Br, 0.55 (1.2 mmol) of 4FTPS-Br was reacted with a mother copolymer of TEA.DIF/ECP. PAG 4 was confirmed by ¹H-NMR of FIG. 11.

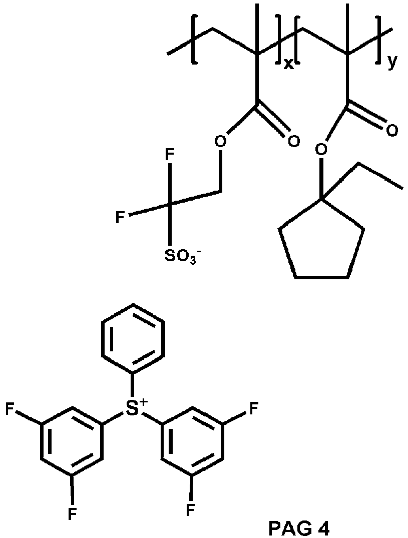

### Synthesis Example 5: Synthesis of PAG 5

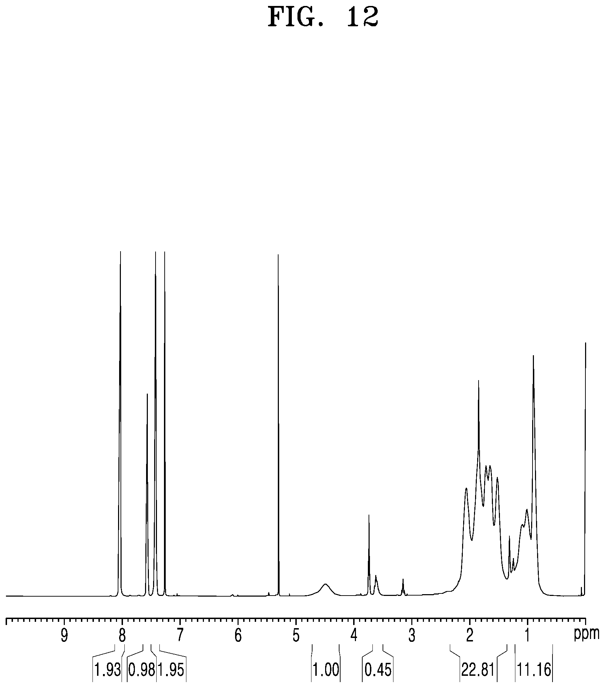

Diphenyliodonium (DPI)/ECP copolymer PAG 5 was synthesized in the same manner as in Synthesis Example 1, except that instead of 0.55 (1.2 mmol) of 1FTPS-Br, 0.55 (1.2 mmol) of DPI-OTf was reacted with a mother copolymer of TEA.DIF/ECP. PAG 5 was confirmed by ¹H-NMR of FIG. 12.

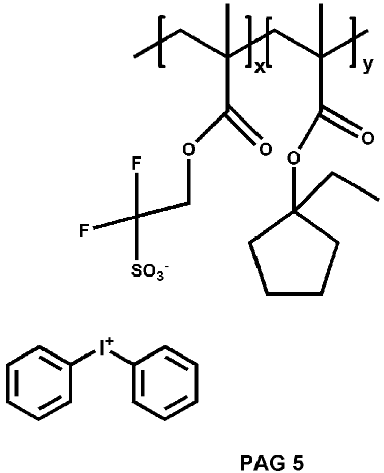

### Synthesis Example 6: Synthesis of PAG 6

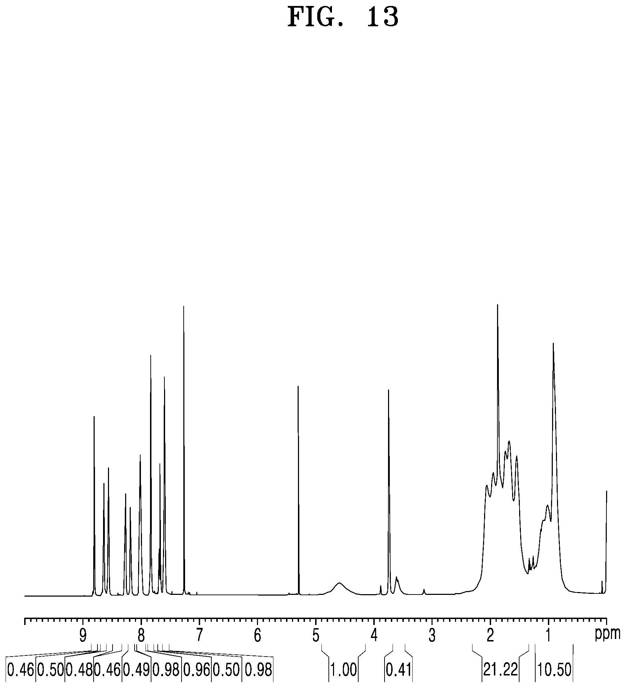

Phenylthioxanthone substituted with methyl fluoride (CF3f)/ECP copolymer PAG 6 was synthesized in the same manner as in Synthesis Example 1, except that instead of 0.55 (1.2 mmol) of 1FTPS-Br, 0.55 (1.2 mmol) of CF3f-Cl was reacted with a mother copolymer of TEA.DIF/ECP. PAG 6 was confirmed by ¹H-NMR of FIG. 13.

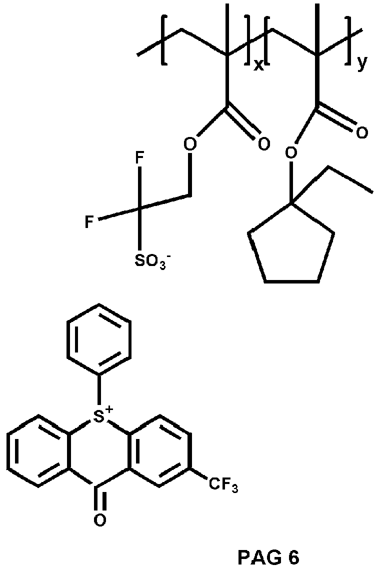

### (Synthesis of Base Polymer)

### Synthesis Example 7: Synthesis of Base Polymer

A copolymer represented by Formula 6-1 was synthesized according to Scheme 2.

1.5 g (9.3 mmol) of acetoxystyrene (AHS), 2.3 g (9.3 mmol) of 2-ethyl-2-adamantyl-methacrylate(EAd-MA), 0.2 g (0.9 mmol) of azo initiator (V601) were dissolved in 18 mL of dioxane and a reaction was carried out at 80 °C for 4 hours to obtain AHS/EAd. 1 g of hydrazine monohydrate was added to AHS/EAd and a reaction was carried out at room temperature for 2 hours to obtain a reactant. Then, 50 mL of deionized water (DW) and 2 g of acetic acid were added to the reactant, an extraction process was carried out with ethyl acetate (EA), then the reactant was precipitated with hexane, and the obtained precipitate was dried at 40 °C for 24 hours to obtain a white powder copolymer represented by Formula 6-1: 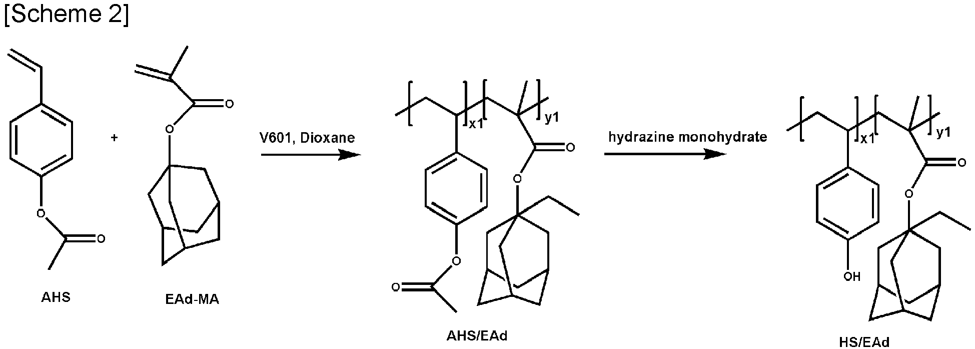 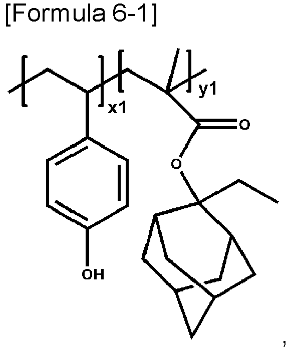 wherein, in Formula 6-1,
x1 and y1 are each 50,
a number average molecular weight (Mn) is 4,000, and
polydispersity index (Mw/Mn, PDI) is 1.3.

### (Preparation of Photoresist Composition)

### Example 1: Preparation of a Photoresist Composition

100 parts by weight of a base polymer prepared according to Synthesis Example 7, 25 parts by weight of a photoacid generator (PAG 1) prepared according to Synthesis Example 1, 12 parts by weight of a photo-decomposable quencher (PDQ) represented by Formula 7, and 7,500 parts by weight of a co-solvent prepared by mixing propylene glycol monomethyl ether and propylene glycol monomethyl ether acetate in a ratio of 70:30, were put into a reactor and mixed to prepare a photoresist composition.

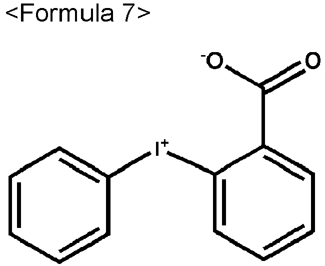

### Example 2: Preparation of Photoresist Composition

A photoresist composition was prepared in the same manner as in Example 1, except that 25 parts by weight of the photoacid generator (PAG 2) prepared according to Synthesis Example 2 was used.

### Example 3: Preparation of Photoresist Composition

A photoresist composition was prepared in the same manner as in Example 1, except that 25 parts by weight of the photoacid generator (PAG 3) prepared according to Synthesis Example 3 was used.

### Example 4: Preparation of Photoresist Composition

A photoresist composition was prepared in the same manner as in Example 1, except that 25 parts by weight of the photoacid generator (PAG 4) prepared according to Synthesis Example 4 was used.

### Example 5: Preparation of Photoresist Composition

A photoresist composition was prepared in the same manner as in Example 1, except that 25 parts by weight of the photoacid generator (PAG 5) prepared according to Synthesis Example 5 was used.

### Example 6: Preparation of Photoresist Composition

A photoresist composition was prepared in the same manner as in Example 1, except that 25 parts by weight of the photoacid generator (PAG 6) prepared according to Synthesis Example 6 was used.

### Comparative Example 1: Preparation of Photoresist Composition

A photoresist composition was prepared in the same manner as in Example 1, except that 25 parts by weight of triphenylsulfonium triflate was used.

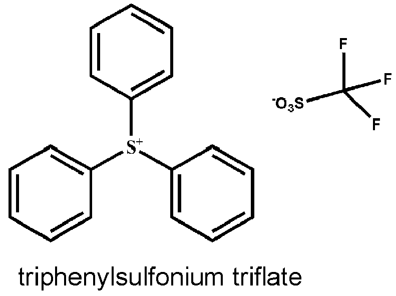

### Evaluation Example 1: Evaluation of Acid Diffusion Length and Acid Yield

An acid diffusion length and acid yield were evaluated in the following method, and the results are shown in Table 1.

### (1) Acid Diffusion Length (ADL)

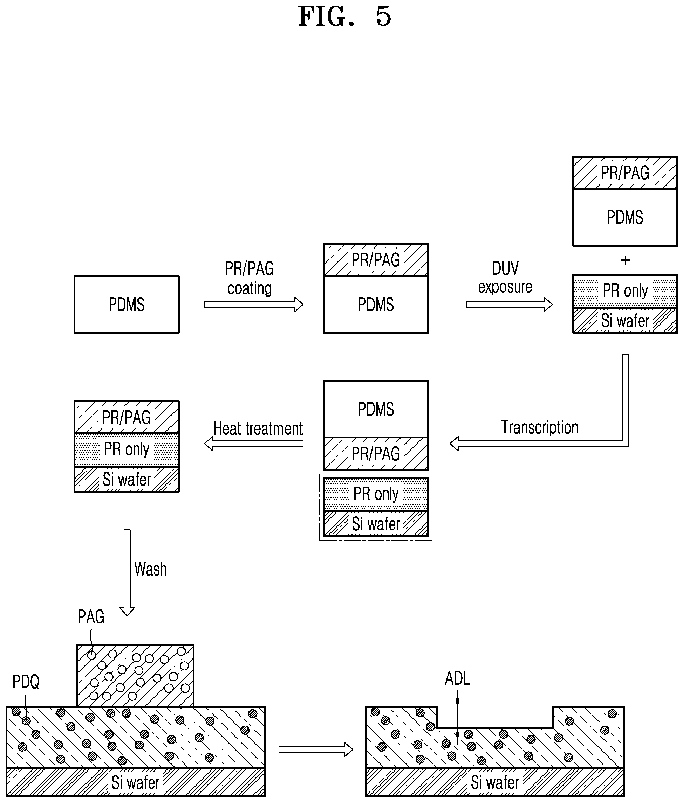

The acid diffusion length is measured as illustrated in FIG. 5, and details thereof are as follows.

Each of the photoresist compositions prepared according to Examples 1 to 6 and Comparative Example 1 was spin-coated on polydimethylsiloxane (PDMS) at 1500 rpm for 30 seconds to a thickness of 100 nm, and was exposed to deep UV (DUV) rays having a wavelength of 248 nm at an intensity of about 100 mJ/cm² to 200 mJ/cm² to form a first photoresist film. Upon exposure, an acid was generated from a photoacid generator in a first photoresist film.

On the other hand, a 12-inch circular silicon wafer substrate was pre-treated under a UV ozone cleaning system for 10 minutes. Each of the photoresist compositions prepared according to Examples 1 to 6 and Comparative Example 1 excluding the photoacid generator (PAG) was spin-coated on a silicon wafer substrate at 1500 rpm for 30 seconds to a thickness of 100 nm, followed by a preliminary heat treatment on a hot plate at 110 °C for 60 seconds to form a second photoresist film.

PDMS on which the first photoresist film was formed and the silicon wafer substrate on which the second photoresist film was formed were overlapped in such a way that the first photoresist film and the second photoresist film were in contact with each other, thereby forming a laminate. The laminate was maintained at 90 °C for 60 seconds to allow the acid generated in the first photoresist film to diffuse into the second photoresist film. Then, the laminate was washed with a 2.38 wt% of tetramethylammonium hydroxide (TMAH) aqueous solution to measure the thickness of the remaining second photoresist film to evaluate the acid diffusion length (ADL).

### (2) Acid Yield (AY)

10 wt% of poly(4-vinylphenol) (Mw=11,000) and 6.5 wt% of Coumarin 6 were dissolved in cyclohexanone, and the same mole of photoacid generators (PAG) of Synthesis Examples 1 to 6 and triphenylsulfonium triflate photoacid generator were added thereto to obtain compositions. Each of the obtained compositions was spin-coated to a thickness of 400 nm on an 1-inch quartz at 1,500 rpm for 30 seconds and dried at 130 °C for 2 minutes to form a photoresist film. Thereafter, the photoresist film was exposed to a deep UV (DUV) radiation having a wavelength of 248 nm at about 10 mJ/cm² to 200 mJ/cm² to measure an absorbance. Assuming that an acid indicator Coumarin 6 was 100% converted to an acid after exposure to a DUV ray at an intensity of 100 mJ/cm², the intensity of an absorbance after exposure to a DUV ray at an intensity of 20 mJ/cm² was normalized and the degrees of acid generation at respective PAGs were compared to evaluate an acid yield.

**[Table 1]**

| | Example 1 (Synthesis Example 1) | Example 2 (Synthesis Example 2) | Example 3 (Synthesis Example 3) | Example 4 (Synthesis Example 4) | Example 5 (Synthesis Example 5) | Example 6 (Synthesis Example 6) | Comparative Example 1 (triphenylsulf onium triflate) |
|---|---|---|---|---|---|---|---|
| Counter cation (B+) | 1FTPS | 2FTPS | 3FTPS | 4FTPS | DPI | CF3f | tri phenyl sulfonium |
| ADL (nm) | 1.0 | 1.2 | 1.1 | 2.7 | 5.0 | 5.1 | 425 |
| AY(%)@20mJ/cm² | 62.5 | 58.6 | 60.5 | 64.4 | 83.1 | 41.5 | 72.4 |

Referring to Table 1, a diffusion length of the acid generated from a photoacid generator (PAG) copolymer (Synthesis Examples 1 to 6) of the photoresist compositions prepared according to Examples 1 to 6 was markedly decreased compared to a diffusion length of the acid generated from the triphenylsulphonium triflate photoacid generator (PAG) prepared according to Comparative Example 1 on a second photoresist film. Among these, the acid yield of the photoacid generator (PAG) of the photoresist composition prepared according to Example 5 was increased compared to the acid yield of triphenylsulphonium triflate photoacid generator (PAG) prepared according to Comparative Example 1.

The decrease in the diffusion length of the acid generated by the photoacid generator (PAG) of the photoresist compositions prepared according to Examples 1 to 6 is construed to be due to the change in the state of the photoacid generator (PAG) from being hydrophobic and insoluble in a developing solvent before exposure to light, to being hydrophilic and soluble in the developing solvent after exposure to light. Accordingly, it can be seen that the photoresist compositions prepared according to Examples 1 to 6 are suitable as chemically amplified photoresist compositions, and enable the formation of a uniform patterning with an improved roughness by using the difference in solubility with respect to a developing solution.

A photoacid generator according to an embodiment includes a copolymer of a monomer that generates an acid upon exposure to light and an acid-labile monomer of which solubility with respect to a developing solvent is changed by decomposition by an acid, wherein the copolymer is represented by the above-described Formula 1. Due to the photoacid generator, the acid diffusion length in a photoresist film may be reduced, and an acid yield may be similar or improved. The photoresist composition including the photoacid generator is suitable for use as a chemically amplified photoresist composition.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A photoacid generator comprising a copolymer of a monomer that generates an acid upon exposure to light and an acid-labile monomer of which solubility with respect to a developing solvent is changed by decomposition by an acid, wherein the copolymer is represented by Formula 1: 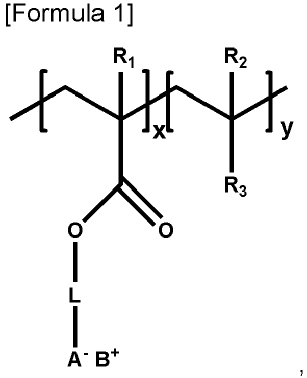 wherein
a molar ratio of x and y is 1: 1 to 1: 5, and a number average molecular weight (Mn) of the copolymer is 500 g/mol to 5,000 g/mol,
L is a single bond or a substituted or unsubstituted C1-C20 alkylene group,
A⁻ is a sulfonic acid anion or a carboxylic acid anion,
B⁺ is a sulfonium-based cation that is unsubstituted or substituted with a halogen atom or a C1-C20 haloalkyl group, or an iodonium-based cation that is unsubstituted or substituted with a halogen atom or a C1-C20 haloalkyl group,
R₁ and R₂ are each independently a hydrogen atom, a halogen atom, or a substituted or unsubstituted C1-C10 alkyl group,
R₃ is one of groups represented by Formulae 1-1 and 1-2:
[Formula 1-1] *-C(=O)O(L₁)ₙRₐ
[Formula 1-2] *-OR_{b},
wherein
L₁ is a C1-C10 alkylene group that is unsubstituted or substituted with a C1-C5 alkyl group,
n is an integer of 0 to 10,
Rₐ is a substituted or unsubstituted C4-C20 t-alkyl group, a substituted or unsubstituted C3-C50 aliphatic cyclic group, a substituted or unsubstituted C3-C60 heteroaliphatic cyclic group, a substituted or unsubstituted C3-C60 heteroaromatic cyclic group, or -OC(=O)ORₐ₁, wherein Rₐ₁ is a C1-C10 alkyl group,
R_{b} is -Si(R_{b1})(R_{b2})(R_{b3}) or -C(R_{b4})(R_{b5})O(R_{b6}), wherein R_{b1}, R_{b2}, R_{b3}, R_{b4}, R_{b5}, and R_{b6} are each independently a hydrogen atom, a C1-C10 alkyl group, or a C6-C20 aryl group, and
* is a binding site.

2. The photoacid generator of claim 1, wherein a polydispersity index (Mw/Mn, PDI) of the copolymer is 1.0 to 3.0.

3. The photoacid generator of claims 1 or 2, wherein B⁺ includes a sulfonium-based cation represented by Formula 2 or an iodonium-based cation represented by Formula 3: 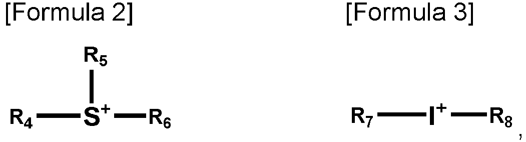 wherein
at least two of R₄, R₅ and R₆ are bonded to each other and form, together with a sulfur atom, a ring that is unsubstituted or substituted with at least one halogen atom or a C1-C20 haloalkyl group, or R₄, R₅ and R₆ are each independently a substituted or unsubstituted C6-C60 aryl group, and
R₇ and R₈ are each independently a substituted or unsubstituted C6-C60 aryl group or a substituted or unsubstituted C6-C60 heteroaryl group.

4. The photoacid generator of any of claims 1-3, wherein B⁺ includes a triphenylsulfonium-based cation that is unsubstituted or substituted with at least one halogen atom or a C1-C20 haloalkyl group, a thioxanthone-based cation that is unsubstituted or substituted with at least one halogen atom or a C1-C20 haloalkyl group, or a diphenyliodonium-based cation that is unsubstituted or substituted with at least one halogen atom or a C1-C20 haloalkyl group.

5. The photoacid generator of any of claims 1-4, wherein B⁺ includes one of sulfonium-based cations or iodonium-based cations represented by Formulae 3-1 to 3-15: 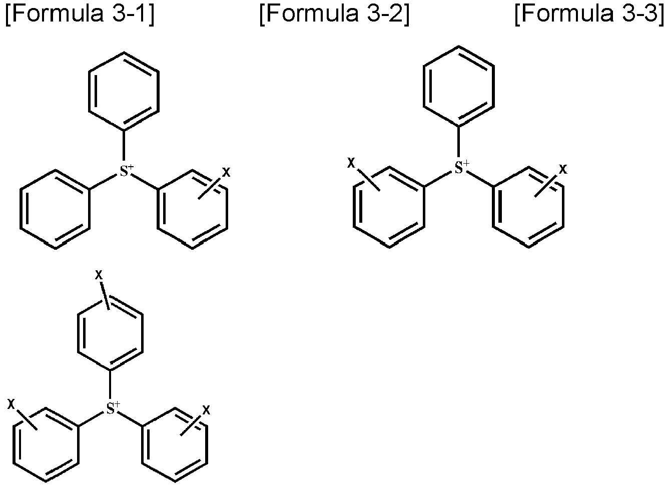 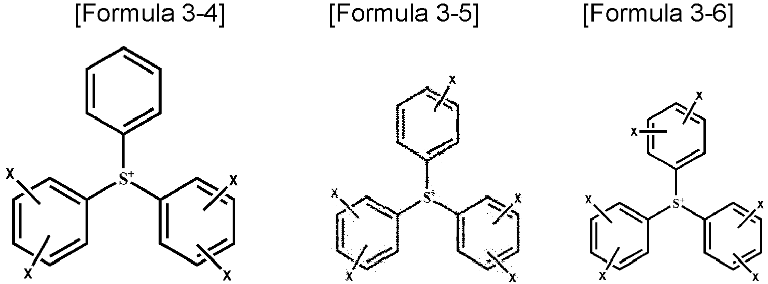 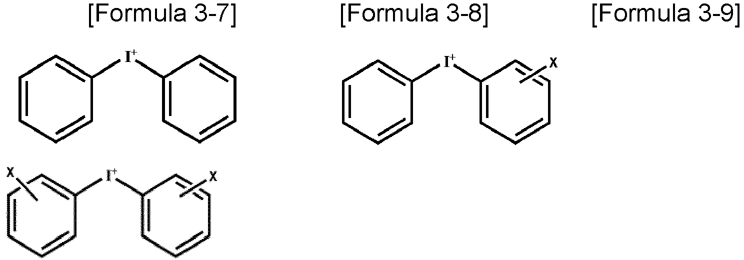 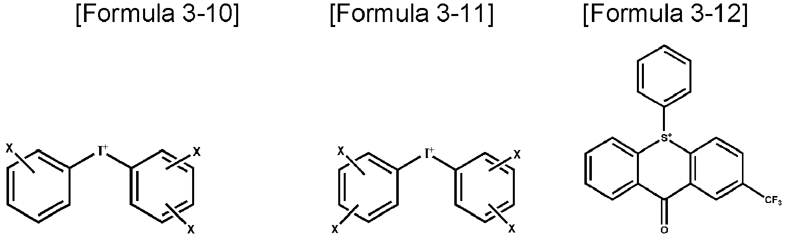 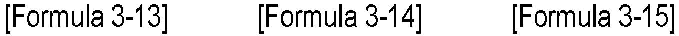 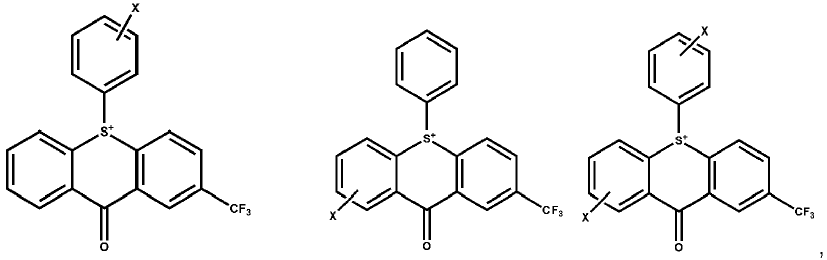 wherein, in Formulae 3-1 to 3-15,
X is a halogen atom.

6. The photoacid generator of any of claims 1-5, wherein
R₃ includes one of substituents represented by Formulae 4-1 to 4-10: 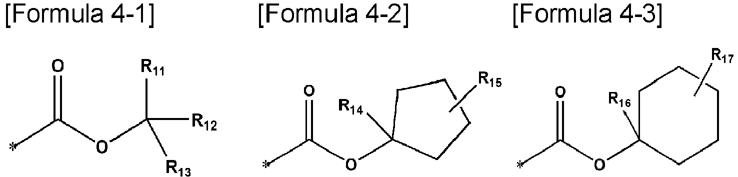 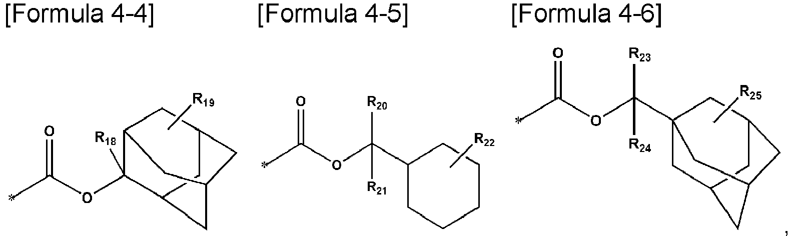 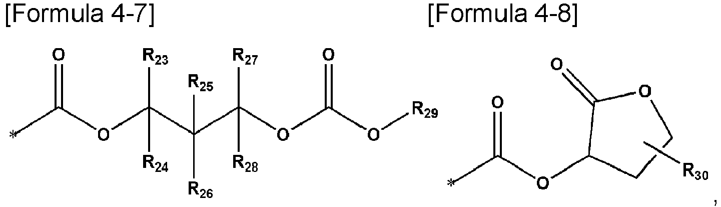 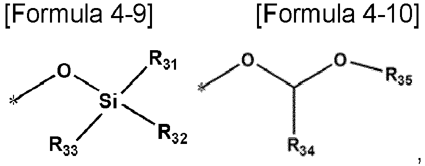 wherein, in Formulae 4-1 to 4-10,
R₁₁, R₁₂, R₁₃, R₁₄, R₁₆, R₁₈, R₂₉, R₃₁, R₃₂, R₃₃, and R₃₅ are each independently a C1-C5 alkyl group or a C6-C20 aryl group,
R₁₅, R₁₇, R₁₉, R₂₀, R₂₁, R₂₂, R₂₃, R₂₄, R₂₅, R₂₆, R₂₇, R₂₈, R₃₀, and R₃₄ are each independently a hydrogen atom or a C1-C5 alkyl group, and
* is a binding site.

7. The photoacid generator of any of claims 1-6, wherein
the copolymer includes a copolymer represented by Formula 5: 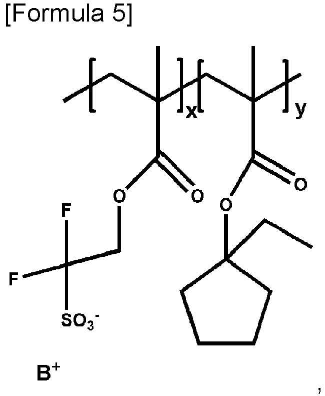 wherein, in Formula 5,
B⁺ is a triphenylsulfonium cation substituted with at least one halogen atom, a thioxanthone cation substituted with at least one halogen atom or a C1-C10 haloalkyl group, or diphenyliodonium that is unsubstituted or substituted with at least one halogen atom.

8. The photoacid generator of any of claims 1-7, wherein, before exposure to light, the photoacid generator is hydrophobic and insoluble in a developing solvent, and after exposure to light, the photoacid generator is hydrophilic and soluble in the developing solvent; and/or
wherein the exposure is made using KrF eximer laser having a wavelength of 248 nm, ArF eximer laser having a wavelength of 193 nm, or extreme ultraviolet (EUV) light having a wavelength of 13.5 nm.

9. A photoresist composition comprising: the photoacid generator according to any of claims 1-8; a base polymer; a photo-decomposable quencher (PDQ); and a solvent.

10. The photoresist composition of claim 9, wherein an amount of the copolymer of the photoacid generator is 5 parts by weight to 70 parts by weight, with respect to 100 parts by weight of the base polymer.

11. The photoresist composition of claims 9 or 10, wherein the base polymer is a copolymer comprising a hydroxystyrene monomer and a monomer comprising an acid degradable protective group, and the monomer comprising the acid degradable protective group comprises one of substituents represented by Formulae 4-1 to 4-10: 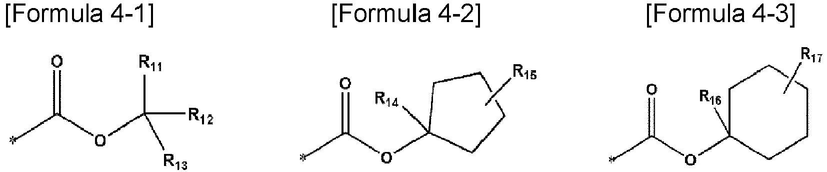 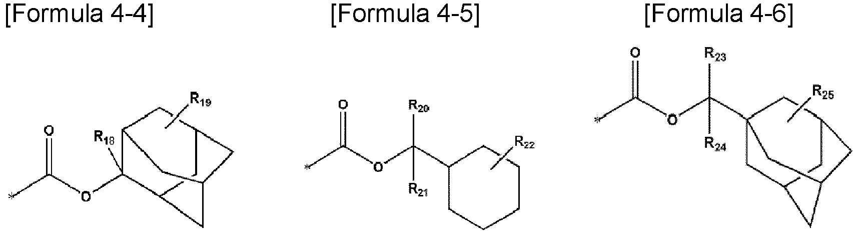 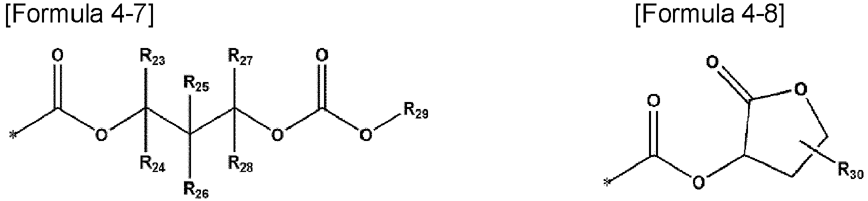 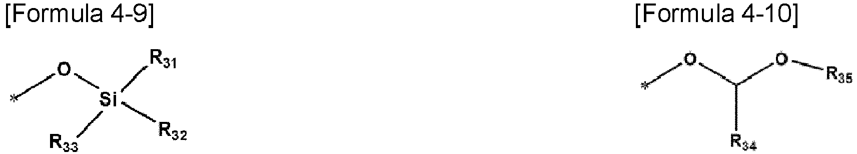 wherein, in Formulae 4-1 to 4-10,
R11, R12, R13, R14, R16, R18, R29, R31, R32, R33, and R35 are each independently a C1-C5 alkyl group or a C6-C20 aryl group,
R15, R17, R19, R20, R21, R22, R23, R24, R25, R26, R27, R28, R30, and R34 are each independently a hydrogen atom or a C1-C5 alkyl group, and
* is a binding site;
preferably wherein a polydispersity index (Mw/Mn, PDI) of the base polymer is 1.0 to 3.0.

12. The photoresist composition of any of claims 9-11, wherein the photo-decomposable quencher includes a quencher represented by Formula 7:

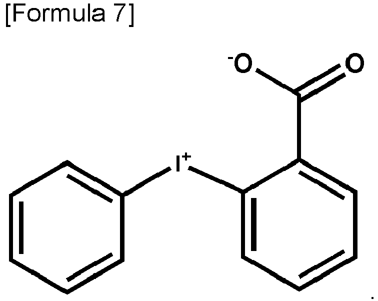

13. The photoresist composition of any of claims 9-12, wherein the photoresist composition is a chemically amplified photoresist composition; and/or
wherein a diffusion length of the acid generated by the photoacid generator in a resist film is controllable to be in a range of 0.01 nm to 10 nm.

14. A method of forming a pattern, the method comprising:
forming a photoresist film by applying a board with the photoresist composition of any of claims 9-13;
exposing at least a portion of the photoresist film with high-energy rays; and
developing the exposed photoresist film by using a developing solution.

15. The method of claim 14, wherein the exposing is performed by irradiating a KrF excimer laser, an ArF excimer laser, extreme ultraviolet (EUV) rays, and/or an electron beam (EB).
